(19) **Europäisches Patentamt**

**European Patent Office**

**Office européen des brevets**

(11) **EP 1 386 689 A1**

(12) **EUROPEAN PATENT APPLICATION**
published in accordance with Art. 158(3) EPC

(43) Date of publication:
**04.02.2004 Bulletin 2004/06**

(51) Int Cl.⁷: **B23K 26/38**, B23K 26/40,
H05K 3/00
// B23K101:42

(21) Application number: **02708719.6**

(22) Date of filing: **29.03.2002**

(86) International application number:
**PCT/JP2002/003150**

(87) International publication number:
**WO 2002/092276 (21.11.2002 Gazette 2002/47)**

(84) Designated Contracting States:
**AT BE CH CY DE DK ES FI FR GB GR IE IT LI LU MC NL PT SE TR**

(30) Priority: **11.05.2001 JP 2001141451**

(71) Applicant: **MITSUBISHI DENKI KABUSHIKI KAISHA**
**Tokyo 100-8310 (JP)**

(72) Inventors:
• **KOBAYASHI, Nobutaka, Mitsubishi Denki K.K.**
**Tokyo 100-8310 (JP)**
• **TAKENO, Shozui, Mitsubishi Denki K.K.**
**Tokyo 100-8310 (JP)**
• **ITO, Kenji, Mitsubishi Denki Kabushiki Kaisha**
**Tokyo 100-8310 (JP)**
• **MORIYASU, Masaharu, Mitsubishi Denki K.K.**
**Tokyo 100-8310 (JP)**

(74) Representative: **Sajda, Wolf E., Dipl.-Phys. et al**
**MEISSNER, BOLTE & PARTNER**
**Postfach 86 06 24**
**81633 München (DE)**

(54) **METHOD AND DEVICE FOR LASER BEAM MACHINING OF LAMINATED MATERIAL**

(57) A method of the present invention is a method for processing a multilayer material, in which one or more conductor layers and insulating layers are layered, with a laser beam. The method includes the step of irradiating the conductor layer with a first laser beam to form a hole at a processing point in the conductor layer, and the step of irradiating the hole with a second laser beam to process the insulating layer, layered on the conductor layer. The second laser beam has a smaller beam diameter at the processing point than the first laser beam.

Fig.3

## Description

BACKGROUND OF THE INVENTION

Field of the invention

The present invention relates to laser processing method and apparatus for a layered material, and more particularly to a method and an apparatus for drilling and grooving by a laser beam in a multi-layer wiring board which is referred to as a printed circuit board.

Description of the Related Art

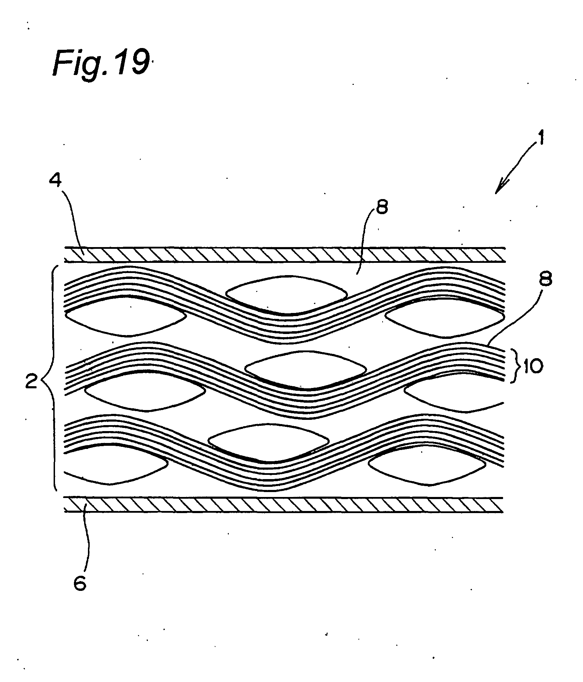

For example, a printed circuit board 1 as shown in Fig. 19 includes an insulator 2, and copper foils 4 and 6 attached to both surfaces of the insulator 2. The insulator 2 is formed by binding forty to sixty glass fibers 8, each of which has a diameter of several μm, into a bundle of fibers (glass cloth) 10, weaving the glass cloth 10 into a mesh configuration, impregnating epoxy resin in the woven glass cloth 10, and curing it.

With respect to this printed circuit board 1, when the two copper foils 4 and 6 attached to the surfaces of the insulator 2 are electrically connected, traditionally, a through-hole, penetrating the print circuit board 1, is formed in the printed circuit board 1 by using a drill, and an inner wall of the through-hole is plated with copper to form a conducting layer.

However, above-mentioned method has some problems. If the through-hole with a hole diameter of φ 200 μm or less is formed by the drill, the drill is considerably damaged and likely to be broken during the drilling process and drilling speed is considerably lowered. Further, if the through-hole is formed by using the drill, a roughness on the cross-sectional surface of the formed through-hole is as large as several dozen micrometers, and therefore it is difficult to form the conducting layer uniformly on the cross-sectional surface by plating.

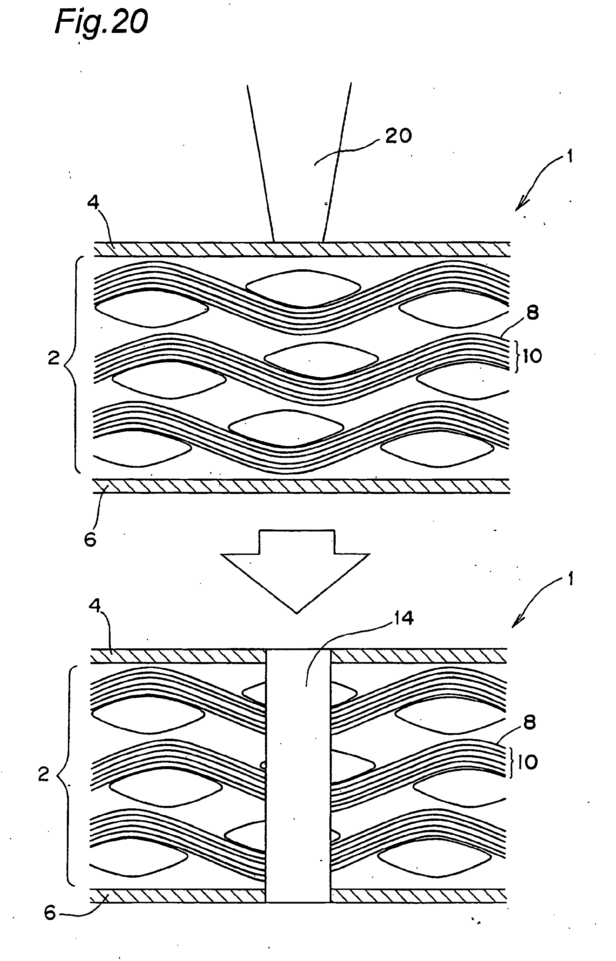

In order to solve the above-mentioned problems, a method of forming a through-hole by using a laser beam, instead of the drill, is proposed in "American Society of Mechanical Engineers" 90-WA/EFP-36. This is, as shown in Fig. 20, the method of forming a through-hole 14 by irradiating the printed circuit board 1 with a laser beam 20 to remove the copper foils 4 and 6, the glass fibers 8 and the epoxy resin.

Furthermore, Japanese Patent Laid-open publication No. 3-27885 discloses a laser processing method, in which a peak output of a pulsed laser beam is varied between when processing the copper foil and when processing the insulator. Explaining this laser processing method with reference to Fig. 19, the copper foils 4 and 6 are processed by using the same laser beams having the higher peak outputs, and the insulator 2 is processed by using the laser beam having the lower peak output. According to this laser processing method, the roughness of the cross-sectional surface of the through-hole can be reduced.

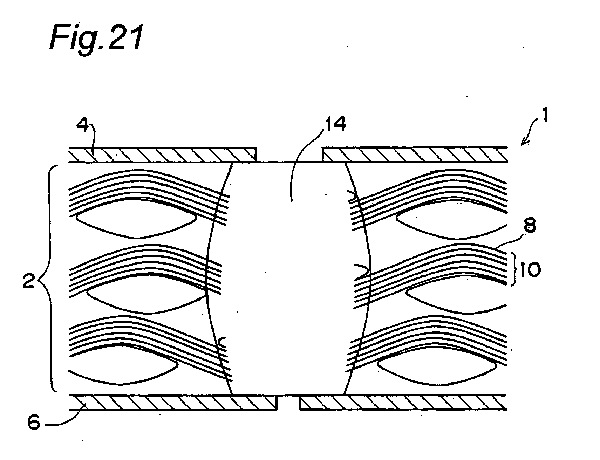

However, as shown in Fig. 21, a laser processing causes a problem that the copper foils 4 and 6 and glass cloth 10 protrude about 20 μm into the inside of the formed through-hole 14. Also, it causes a problem that the through-hole 14 is swollen in the middle thereof. Furthermore, it causes a problem that the hole diameters of the through-hole 14 are different substantially between copper foils 4 and 6. If those problems arise: the copper foils 4 and 6 and glass cloth 10 protrude 10 μm or more into the inside of the formed through-hole 14, the through-hole 14 is swollen in the middle thereof, or the hole diameters of the through-hole 14 are different substantially between copper foils 4 and 6, it is difficult to form the uniform conducting layer on the inner wall of the through-hole 14, and reliability of electrical connection between the copper foils 4 and 6 is lowered.

The above-mentioned problems apply to the cases that a blind via hole is formed in the printed circuit board 1, and that grooving processing is performed therein. If the copper foil 4 or the glass cloth 10 protrudes about 20 μm into the blind via-hole or the groove, or if the configuration of the processed hole or the groove becomes a trapezoid or the like, a conducting film such as a metal film cannot be uniformly formed on the inner wall of the blind via hole or the groove.

Furthermore, it is desired that the time for laser processing is shortened.

Summary of the Invention

It is an object of the present invention to provide a laser processing method and apparatus which realize a high-reliability processing, in which a part of a multilayer material will not protrude into the inside of a hole or a groove, and a configuration of the hole can become a desired one, when laser processing such as drilling or grooving is performed in the multilayer wiring substrate.

A first method according to the present invention is a method for processing a multilayer material, in which one or more conductor layers and insulating layers are layered, with a laser beam. This method includes the steps of irradiating the conductor layer with a first laser beam to form a hole at a processing point in the conductor layer, and irradiating the hole with a second laser beam to process the insulating layer, layered on the conductor layer. The second laser beam has a smaller beam diameter at the processing point than the first laser beam.

A second method according to the present invention is a method for processing a multilayer material, in which one or more conductor layers and insulating layers are layered, with a laser beam to form a through-hole in the multilayer material. Here, a surface layer on the laser outgoing side of the multilayer material is the conductor layer. This method includes the steps of forming a laser beam absorbing material on this surface layer, and forming the through-hole in the multilayer material.

Preferably, in the second method, the laser beam absorbing material is a polymeric material.

Further, the second method can be combined with the first method.

A third method of the present invention is a method for processing a multilayer material, in which one or more conductor layers and insulating layers are layered, with a laser beam to form a hole. This method includes the steps of pre-heating a part of the conductor layer, and irradiating the part heated in the pre-heating step with a laser beam to form the hole.

Preferably, in the third method, the pre-heating step is performed by irradiating the part of the conductor layer with a laser beam.

Further, the third method can be combined with the first method. In that case, preferably, the first method includes steps of pre-heating a part of the conductor layer before the step of irradiating the conductor layer. Then, in the step of irradiating the conductor layer with the first laser beam, the part heated in the pre-heating step is irradiated with the first laser beam to form the hole.

Further, the third method can be combined with the second method. In that case, the part of the conductor layer may previously pre-heated, then the heated part may irradiated with a laser beam, while the laser beam absorbing material is formed on the surface layer (conductor layer) on the laser outgoing side of the multilayer material.

Further, the third method can be combined with the first and second methods.

A fourth method is a method for processing a multilayer material with a laser beam to form a through-hole in the multilayer material, in which a conductor layer and an insulating layer are layered, and which includes a multilayer consisting of two conductor layers and an insulating layer interposed between the two conductor layers. This method includes the steps of irradiating a first conductor layer of the two conductor layers in the multilayer with a first laser beam to form a hole at a processing point in the first conductor, irradiating the hole formed by the irradiating step for the first conductor layer with a second laser beam, having lower peak output than the first laser beam, to process the insulating layer in the multilayer, while a beam diameter at the processing point is kept constant, and irradiating the hole formed by the irradiating step for the insulating layer with a third laser beam, having lower peak output than the first laser beam and having higher peak output than the second laser beam, to process a second conductor layer of the two conductor layer in the multilayer, while the beam diameter at the processing point is kept constant.

Further, the fourth method can be combined with the first method. In that case, in the multilayer consisting of two conductor layers and an insulating layer interposed between the two conductor layers, the first conductor layer is irradiated with a first laser beam to form the hole, then the hole is irradiated with the second laser beam, having lower peak output and smaller beam diameter at the processing point than the first laser beam, to process the insulating layer.

Further, the fourth method can be combined with the second method. For example, if the second conductor layer in the multilayer is a surface layer of the multilayer material, the fourth method preferably includes the step of forming the laser beam absorbing material on the second layer before the step of irradiating the first conductor layer with the first laser beam.

Further, the fourth method can be combined with the third method. In that case, if one of the two conductor layers is irradiated with a laser beam, a part of the conductor layer may previously pre-heated, then the heated part may irradiated with the laser beam.

Further, the fourth method is combined with any two or all of the first method, the second method, and the third method.

A fifth method is a method for processing a multilayer material with a laser beam to form a through-hole in the multilayer material, in which a conductor layer and an insulating layer are layered, and which includes a multilayer consisting of two conductor layers and an insulating layer interposed between the two conductor layers. This method includes the steps of irradiating a first conductor layer of the two conductor layers in the multilayer with a first laser beam to form a hole at a processing point in the first conductor, irradiating the hole formed by the irradiating step for the first conductor layer with a second laser beam, having lower power density than the first laser beam, to process the insulating layer in the multilayer, and irradiating the hole formed by the irradiating step for the insulating layer with a third laser beam, having lower power density than the first laser beam and having higher power density than the second laser beam, to process a second conductor layer of the two conductor layer in the multilayer.

A sixth method is a method for processing a multilayer material with a pulsed laser beam to form a through-hole in the multilayer material, in which a conductor layer and an insulating layer are layered, and which includes a multilayer consisting of two conductor layers and an insulating layer interposed between the two conductor layers. This method includes the steps of irradiating a first conductor layer of the two conductor layers in the multilayer with a first laser beam to form a hole at a processing point in the first conductor, irradiating the hole formed by the irradiating step for the first conductor layer with a second laser beam, having lower peak output and wider pulse width than the first laser beam, to process the insulating layer in the multilayer, while a beam diameter at the processing point is kept constant, and irradiating the hole formed by the irradiating step for the insulating layer with a third laser beam, having lower peak output and wider pulse width than the first laser beam and having higher peak output and narrower pulse width than the second laser beam, to process a second conductor layer of the two conductor layer in the multilayer, while the beam diameter at the processing point is kept constant.

A laser processing apparatus of the present invention is a laser processing apparatus for a multilayer material to irradiate the multilayer material, in which one or more conductor layers and insulating layers are layered, with a laser beam. This laser processing apparatus includes a laser which emits a pulsed laser beam, of which peak output is variable, an opening which passes a part of the pulsed laser beam emitted from the laser, a first optical system which varies an optical path of the laser beam passing the opening, an imaging lens which forms an image of the opening, and a controller which controls positions and operations of the laser, the opening, the first optical system and the imaging lens. The controller varies a size of the image of the opening.

Preferably, the laser processing apparatus further includes a second optical system which varies an optical path length in an optical path between the opening and the first optical system. The controller controls the second optical system to vary a distance between the opening and the imaging lens.

Preferably, the laser processing apparatus further includes a reflecting mirror in an optical path between the opening and the first optical system. The controller varies a shape of a reflective surface of the reflecting mirror.

Preferably, in the laser processing apparatus, the controller makes the shape of the reflective surface of the reflecting mirror a part of hyperboloid of revolution.

Preferably, in the laser processing apparatus, the controller varies the shape of the reflective surface of the reflecting mirror by controlling a piezoelectric device mounted on the reflecting mirror.

Preferably, in the laser processing apparatus, the controller varies an opening diameter of the opening.

Preferably, in the laser processing apparatus, the controller varies a focal distance of the imaging lens.

(Advantages of the invention)

According to the method for laser processing a multilayer material of the present invention, a through-hole is prevented from being swollen in the middle.

According to the method for laser processing a multilayer material of the present invention, variation of a hole diameter can be reduced in a copper foil, which is a surface layer on the laser inputting side of the multilayer material.

According to the method for laser processing a multilayer material of the present invention, a copper foil and a glass cloth can be prevented from protruding into a through-hole.

According to the method for laser processing a the multilayer material of the present invention, variation of a hole diameter can be reduced in a copper foil, which is a surface layer on the laser outputting side of the multilayer material.

According to the method for laser processing a multilayer material of the present invention, a laser beam diameter can be easily varied, and a through-hole can be easily prevented from being swollen in the middle.

BRIEF DESCRIPTION OF THE DRAWINGS

Fig. 1 is a diagram to explain a laser processing method for a multilayer material according to an embodiment 1 of the present invention.
Fig. 2 is a graph to explain laser beams' abilities of processing a copper foil when one pulse of each of the laser beams, having different pulse widths and different energies per pulse to each other, is irradiated onto the surface on which the copper foil is uniformly formed, with the equal focused diameter.
Fig. 3 is a diagram to explain a laser processing method for a multilayer material according to an embodiment 2 of the present invention.
Fig. 4 is a diagram of a laser processing apparatus for a multilayer material according to an embodiment 2 of the present invention.
Fig. 5 is a diagram of an opening diameter continuously variable beam aperture.
Fig. 6 is a diagram to explain a laser processing method for a multilayer material according to an embodiment 3 of the present invention.
Fig. 7 is a diagram of a basic configuration of an imaging optics.
Fig. 8 is a diagram to explain a laser processing apparatus for a multilayer material according to an embodiment 4 of the present invention.
Fig. 9 is a diagram of a basic configuration of the imaging optics in which a convex mirror and a concave mirror are used.
Fig. 10 is a diagram to explain reflection depending on a configuration of a reflective surface of a reflecting mirror.
Fig. 11 is a diagram to explain a configuration of a reflective surface shape variable reflecting mirror used in the laser processing apparatus shown in Fig. 8;
Fig. 12 is a diagram of a laser processing apparatus for a multilayer material according to an embodiment 5 of the present invention.
Fig. 13 is a diagram to explain a converging by an opening and a lens.
Fig. 14 is a diagram to explain a laser processing apparatus for a multilayer material according to an embodiment 6 of the present invention.
Fig. 15 is a diagram of a focal distance variable transfer lens.

Fig. 16 is a diagram to explain steps of a laser processing method for a multilayer material according to an embodiment 7 of the present invention;

Fig. 17 is a diagram to explain a laser processing method for a multilayer material according to an embodiment 8 of the present invention.

Fig. 18 is a graph to show temperature dependency of carbon dioxide laser absorptance of copper.

Fig. 19 is a cross-sectional view of a printed circuit board.

Fig. 20 is a diagram to explain processes of forming a through-hole according to the conventional laser processing.

Fig. 21 is a diagram of a cross-section of the through-hole formed by the conventional laser processing.

## DESCRIPTION OF THE PREFERRED EMBODIMENTS

The following is a detailed description of the main embodiments of the invention, with reference to the drawings in which the same numerical references identify the same elements in each of the different drawings.

### (Embodiment 1)

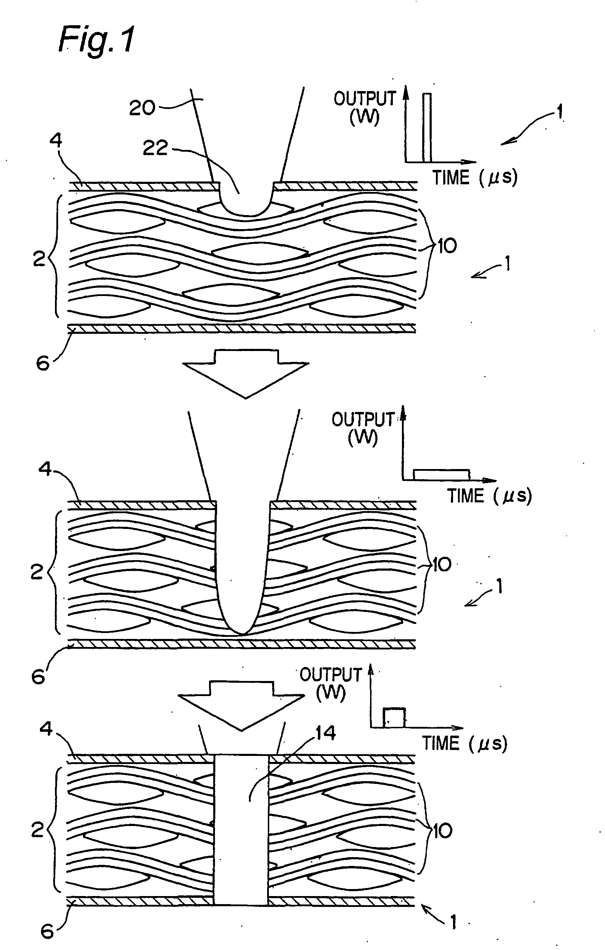

Fig. 1 is a diagram to explain steps of a laser processing method for a multilayer material according to a first embodiment of the present invention. In the description of this embodiment, the multilayer material means a multi-layer wiring board, which is referred to as a printed circuit board. As shown in Fig. 1, the printed circuit board 1 includes an insulator (an insulating layer) 2, copper foils (conductor layers) 4 and 6 attached to both surfaces of the insulator 2. The insulator 2, which is made of a glass epoxy resin, is formed by binding forty to sixty glass fibers 8, each of which has a diameter of several $\mu$m, into a bundle of fibers (glass cloth) 10, weaving the glass cloth 10 into a mesh configuration, impregnating epoxy resin in the woven glass cloth 10, and curing it. According to the processes shown in Fig. 1, a through-hole 14 is formed by irradiating a pulsed carbon dioxide laser beam to a double-sided copper-clad printed circuit board (the glass epoxy substrate) 1 with a thickness of 0.4mm in which each thickness of the copper foils 4 and 6 is 12 $\mu$m.

First, a laser beam 20 converged into $\phi$ 120 $\mu$m is irradiated onto the copper foil 4 to form a drilled hole 22 in the surface of the copper foil 4. The drilled hole 22 of $\phi$ 100 $\mu$m is formed in the surface of the copper foil 4 by irradiating the copper foil 4 with one pulse of the laser beam, in which a pulse on time (a pulse width) of the laser beam is set to 3 $\mu$s, and the laser energy per one pulse thereof is set to 24 mJ. In the following processing, a focused diameter of the laser beam (the laser beam diameter at a processing point) is fixed to $\phi$ 120 $\mu$m.

Then, the insulator 2 is processed by irradiating the same position as the drilled hole 22 with four pulses of the laser beam, in which the pulse on time of the laser beam is set to 100 $\mu$s and laser energy per pulse is set to 10 mJ. Then, the copper foil 6 is processed by irradiating the same position with one pulse of the laser beam, in which the pulse on time of the laser beam is set to 40 $\mu$s and laser energy per pulse is set to 8 mJ. As a result, the through-hole 14 of $\phi$ 100 $\mu$m is formed in the printed circuit board 1.

An observation of a cross-section of the through-hole 14 by a microscope shows that its hole diameter hardly changes, and the direction of the central axis of the hole corresponds to that of the optical axis of the laser beam. In addition, it is found that protrusions of the copper foil 4 into the hole on the laser incoming side of the hole and that of the copper foil 6 into the hole on the laser outgoing side of the hole are 5 $\mu$m or less, which means there is almost no protrusion of the glass cloth 10 into the hole.

For comparison with the drilling process having the steps shown in Fig. 1, a through-hole is formed by different steps by using the same printed circuit board and the same kind of laser beam. Those comparative experiments will be described in detail, hereinafter. In the following comparative experiments, the focused diameter of the laser beam irradiated onto the copper foil 4, the insulator 2 and the copper foil 6 is fixed to $\phi$ 120 $\mu$m. In the first comparative experiment, one pulse of a laser beam is irradiated onto the printed circuit board 1, in which the laser beam is set to the condition in which the copper foil 4 is processed as shown in Fig. 1 (the pulse on time of the laser beam is 3 $\mu$s, and the laser energy per pulse is 24 mJ). Then, five pulses of the laser beam are irradiated onto the same position, in which the pulse on time of the laser beam is set to 100 $\mu$s, and the laser energy per pulse is set to 10 mJ. As a result of those steps, the through-hole 14 is formed in the printed circuit board 1. However, an observation of a cross-section of the through-hole 14 by a microscope shows that the copper foil 6 protrudes about 20 $\mu$m into the through-hole 14 on the laser outgoing side thereof.

Furthermore, in the second comparative experiment, five pulses of the laser beam are successively irradiated onto the printed circuit board 1, with the laser beam being set to the condition in which the copper foil 4 is processed as shown in Fig. 1 (the pulse on time of the laser beam is 3 $\mu$s, and the laser energy per pulse is 24 mJ). As a result of this step, the through-hole 14 is formed in the printed circuit board 1. However an observation of a cross-section of the through-hole 14 by the microscope shows that the through-hole 14 is swollen in the middle, and the copper foil 4 on the laser incoming side of the hole 14, the copper foil 6 on the laser outgoing.side thereof and the glass cloth 10 protrude about 20 $\mu$m into the through-hole 14.

Still further, in the third comparative experiment, one pulse of the laser beam is irradiated onto the printed circuit board 1, with the laser beam being set to the condition in which the copper foil 4 is processed as shown in Fig. 1 (the pulse on time of the laser beam is 3 µs, and the laser energy per pulse is 24 mJ). Then, four pulses of the laser beam are irradiated onto the same position, in which the pulse on time of the laser beam is 100 µs, and the laser energy per pulse is 10 mJ. Then, one pulse of the laser beam is irradiated onto the same position, in which the pulse on time of the laser beam is 3 µs, and the laser energy per pulse is 24 mJ. As a result of those steps, the through-hole 14 is formed in the printed circuit board 1. However, an observation of a cross-section of the through-hole 14 by the microscope shows that the copper foil 6 protrudes about 20 µm into the through-hole 14 on the laser outgoing side of the hole 14. In addition, the method of the third comparative experiment is the same as that described in the above-mentioned Japanese Patent Laid-open Publication No. 3-27885. In this case, the copper foils 4 and 6 are processed by using the same laser beam having the higher peak output, and the insulator 2 is processed by using the laser beam having the lower peak output.

Furthermore, in the fourth comparative experiment, one pulse of the laser beam is irradiated onto the printed circuit board 1, with the laser beam is set to the condition in which the copper foil 4 is processed as shown in Fig. 1 (the pulse on time of the laser beam is 3 µs, and the laser energy per pulse is 24 mJ). Then, ten pulses of the laser beam are irradiated onto the same position, in which the pulse on time of the laser beam is set to 1 µs, and the laser energy per pulse is set to 10 mJ. As a result of those steps, the through-hole 14 is formed in the printed circuit board 1. However, an observation of a cross-section of the through-hole 14 by the microscope shows that the through-hole 14 is swollen in the middle, and the copper foil 4 on the laser incoming side of the hole 14, the copper foil 6 on the laser outgoing side of the hole 14, and the glass cloth 10 protrude about 20 µm into the through-hole 14.

In the laser processing method according to this embodiment, the laser beam conditions among when the copper foil 4 is processed (the pulse on time of the laser beam is 3 µs, and the laser energy per pulse is 24 mJ), when the insulator 2 is processed (the pulse on time of the laser beam is 100 µs, and the laser energy per pulse is 10 mJ) , and when the copper foil 6 is processed (the pulse on time of the laser beam is 40 µs, and the laser energy per pulse is 8 mJ) are different. Here, the peak output of the laser beam by which each material is processed is calculated by using the following equation (1).

Peak output = energy per pulse / pulse on time (pulse

width) (1)

According to the above equation (1), the peak output (8kW) of the laser beam by which the copper foil 4 is processed is higher than the peak output (100W) thereof by which the insulator 2 is processed and the peak output (200W) thereof by which the copper foil 6 is processed. In addition, the peak output (200W) of the laser beam by which the copper foil 6 is processed is higher than the peak output (100W) thereof by which the insulator 2 is processed.

Furthermore, the pulse width (3 µs) of the laser beam by which the copper foil 4 is processed is narrower than the pulse width (100 µs) thereof by which the insulator 2 is processed and the pulse width (40 µs) thereof by which the copper foil 6 is processed. In addition, the pulse width (40 µs) of the laser beam by which the copper foil 6 is processed is narrower than the pulse width (100 µs) thereof by which the insulator 2 is processed. Hereinafter, it is described in detail about setting of the peak output and the pulse width of the laser beam.

First, it is described about setting the value of the peak output of the laser beam. The most important parameter which decides a processing state of the material in the laser processing is power density of the laser beam, which is designated by the following equation (2).

Power density = peak output of laser beam / focused

diameter of laser beam (2)

However, following discussion is made by considering the value of the peak output of laser beam, instead of the value of the power density thereof which should be normally considered, since the focused diameter of the irradiated laser beam is kept constant ($\phi$ 120 µm) in the laser processing methods according to this embodiment and comparative experiments.

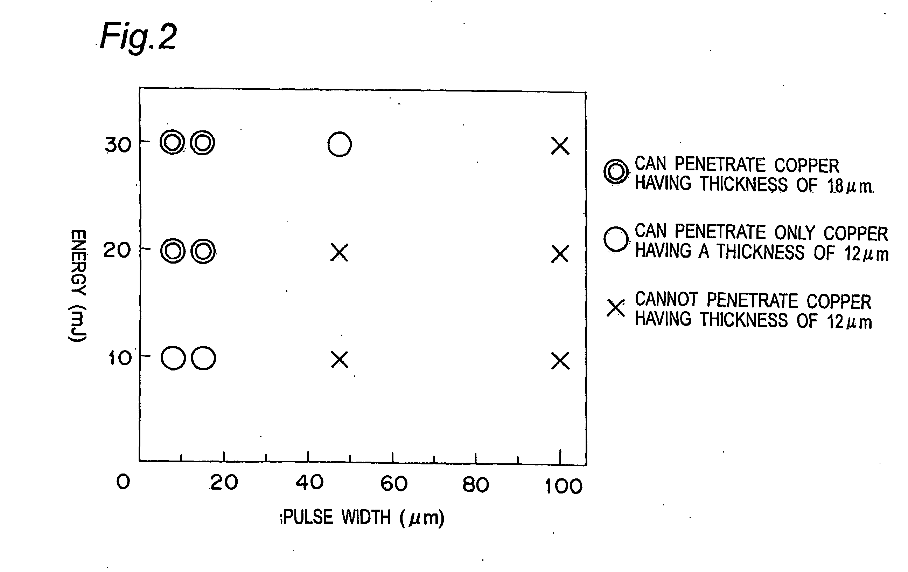

First, it is described about the condition of the laser beam by which the copper foils 4 and 6 are processed. Copper is generally difficult to be processed with a laser beam, since it has high reflection coefficient of a laser beam and high thermal conductance. Especially, the copper foils such as the copper foils 4 and 6, which are uniformly formed on the surface of the printed circuit board, are difficult to be processed with a laser beam, since they reflect almost 99% of the irradiated carbon dioxide laser' beam when it is irradiated onto the uniform surface. Fig. 2 is a graph to explain laser beams' abilities of processing a copper foil when one pulse of each of the laser beams, having different pulse widths and different energies per pulse to each other, is irradiated onto the surface on which the copper foil is uniformly formed with the equal focused diameter. The horizontal axis and longitudinal axis of the graph represent the pulse width of the laser beam and the energy per pulse thereof, respectively. In this graph, ◎ is marked at an intersection point of a value of a pulse width and a value of energy per pulse, when the copper foil having a thickness of 18

μm can be penetrated by being irradiated with a laser beam having the pulse width and the energy per pulse. Similarly, ○ is marked at an intersection point of a value of a pulse width and a value of energy per pulse, when the copper foil of 12 μm can be penetrated but the copper foil of 18 μm cannot be penetrated by being irradiated with a laser beam having the pulse width and the energy per pulse. Similarly, X is marked at an intersection point of a value of a pulse width and a value of energy per pulse, when both copper foils of 12 μm and 18 μm cannot be penetrated by being irradiated with a laser beam having the pulse width and the energy per pulse. When the peak output is calculated by the equation (1), by using the pulse width of the laser beam and the energy per pulse thereof shown in Fig. 2, if the focused beam diameter is constant, the higher the peak output of the laser beam is, the higher the laser beam's ability of penetrating the copper foil is.

Referring to the graph shown in Fig. 2, in the laser processing method according to this embodiment, the laser beam (the pulse on time of the laser beam is 3 μs, and laser energy per pulse thereof is 24 mJ) for processing the copper foil 4 has a high peak output (8kW), which is enough to be able to penetrate the copper foil having the thickness of 18 μm, so that it can sufficiently process the copper foil having the thickness of 12 μm used in the laser processing method according to this embodiment. In other words, the laser beam condition (the peak output of the laser beam is about 1kW or more), as marked by @ in the graph shown by Fig. 2, is necessary in order to process the copper foil 4.

Meanwhile, in the laser processing method according to this embodiment, the laser beam (the pulse on time is 40 μs, and the laser energy per pulse is 8 mJ) for processing the copper foil 6 has the lower peak output (200W) than that for processing the copper foil 4, and cannot penetrate sufficiently the copper foil having the thickness of 12 μm, as shown in the graph in Fig. 2.

In the laser processing method of this embodiment, the surface of the copper foil 6 onto which the laser beam is irradiated is a resin side surface thereof, differently from the case of the copper foil 4. This resin side surface is roughened in order to improve adhesiveness with the resin, and its reflection coefficient of the carbon dioxide laser is 60% to 70%. This is lower than uniform surface's reflection coefficient (about 99%) of the carbon dioxide laser. Therefore, in the laser processing method according to this embodiment, a peak output of the laser beam for processing the copper foil 6 is not necessary to be as high as that for processing the copper foil 4.

However, there is still a fact that the copper foil 6 is difficult to be processed with a laser beam, since it has relatively high thermal conductivity and high reflection coefficient because of its material characteristic. Thus, the laser beam need to have a certain degree of peak output in order to process the copper foil 6. For example, in the first comparative experiment, the protrusion of the copper foil 6 into the through-hole 14 is generated, when the laser beam having the low peak output (100W), which is the same as the laser beam for processing the insulator 2, is irradiated onto the copper foil 6.

Next, it is described about the condition of the laser beam by which the insulator 2 is processed. When processing the insulator 2, it is necessary to make the peak output of the laser beam lower than that of the laser beam when processing the copper foils 4 and 6. First, the condition of the laser beam for processing the insulator 2 will be described, with respect to the protrusion of the glass cloth 10 into the through-hole 14.

During the laser processing, a laser beam is absorbed, refracted and diffused by a removed material generated by the laser processing. Here, the removed material indicates a molten resin or glass generated by irradiation with the laser beam, a residue generated by combustion of the resin or the glass and so on. In drilling process, the laser beam is likely to be absorbed, refracted and diffused as compared with the processing in the vicinity of the surface, since the removed material generated during the processing is confined in a hole. The phenomenon such as the absorption becomes prominent as the power density of the laser beam is increased.

If the laser beam having high power density is used in processing the insulator 2, it is quite likely to be absorbed, refracted and diffused by generation of the removed material. If the laser beam for processing is refracted and diffused, then power density of the laser beam decreases. Here, by the laser beam having the lowered power density, only the epoxy resin is processed in the inner wall of the through-hole 14, since the epoxy resin is more easily processed than the glass cloth 10. As a result, the protrusion of the glass cloth 10 is generated in the through-hole 14. For example, as in the second and fourth comparative experiments, when processing the insulator 2 by irradiating it with the laser beam, of which the peak output is the same (8kW) as or more (10kW) than that of the laser beam used in processing the copper foil 4, the protrusion of the glass cloth 10 is generated.

Also when the laser beam having the high peak output is used in processing the copper foil 6, it is difficult to process the copper foil 6, since the power density of the laser beam is lowered because of the absorption or the like. Thus, the protrusion of the copper foil 6 is likely to be generated in the through-hole 14. For example, as in the third and fourth comparative experiments, when processing the copper foil 6 by irradiating it with the laser beam, of which the peak output is same (8kW) as or more (10kW) than that of the laser beam used in processing the copper foil 4, the protrusion of the glass cloth 10 is generated.

According to the laser processing method of this embodiment, the peak output of the laser beam is lower when processing the insulator 2 and the copper foil 6 than when processing the copper foil 4. Thus, the power density of the laser beam is lower when processing the insulator 2 and the copper foil 6 than when processing the copper foil 4. Therefore, when processing the insulator 2 and the copper foil 6, the laser beam can be prevented from being absorbed, refracted and diffused due to the removed material, and the glass cloth 10 and the copper foil 6 can be prevented from protruding in the through-hole 14 as compared with when processing the copper foil 4.

Next, it is described about the condition of the laser beam by which the insulator 2 is processed, with respect to the configuration of the through-hole 14. When a laser beam is irradiated onto the same position as the drilled hole 22 after forming it in the copper foil 4, diffraction phenomena of the laser beam occurs at the drilled hole 22 in the copper foil 4. The laser passing the copper foil 4 is enlarged at a certain angle because of those diffraction phenomena. The diffracted angle is in proportion to a laser wavelength, and in inverse proportion to the diameter of the drilled hole 22.

In general, the laser beam passing through the drilled hole 22 is enlarged by the diffraction, and its power density is lowered. However, the minimum power density of the laser beam by which the copper foil 4 can be processed is considerably larger than that of the laser beam by which the resin and the glass cloth 10 can be processed. If the laser beam having high peak output is used in processing the resin or the glass cloth 10 as well as in processing the copper foil 4, the processed through-hole 14 is swollen in the middle, since the laser beam enlarged after passing the drilled hole 22 in the copper foil 4 has the large power density enough to process the resin or the glass cloth 10. For example, as in the second and fourth comparative experiments, when irradiating the resin or the glass cloth 10 with the laser beam, of which the peak output is same (8kW) as or more (10kW) than that of the laser beam used in processing the copper foil 4, the processed through-hole 14 is swollen in the middle.

According to the laser processing method of this embodiment, the power density of the diffracted light is equal to or lower than the minimum power density of the laser beam, by which the resin or the glass cloth 10 can be processed, since the insulator 2 is irradiated with the laser beam having the low peak output when processing the insulator 2 after the copper foil 4. This enables to prevent the through-hole 14 from being swollen in the middle.

According to the laser processing method of this embodiment, the power density of the laser beam is varied by varying the peak output of the laser beam, since the laser beam diameter at the processing point is constant. However, referring to the equation (2), it can be also varied when the laser beam diameter at the processing point is variable. Thus, in the method of this embodiment, the power density can be varied by varying the laser beam diameter at the processing point. For example, the laser beam having a larger beam diameter at the processing point may be irradiated onto the insulator 2 than the laser beam irradiated onto the copper foil 4, in order to lower the power density of the laser beam when processing the insulator 2. Even in that case, the beam diameter of the laser beam irradiated onto the insulator 2 becomes equal to that of the laser beam by which the copper foil 4 is processed, since the laser beam irradiated onto the outside of the drilled hole 22, formed in the copper foil 4, is reflected by the copper foil 4. Therefore, even if the laser beam diameter at the processing point is made variable, it is possible to form the through-hole 14 having a constant hole diameter in its cross section.

Next, it will be described about setting the value of the pulse width of the laser beam. In general, in the laser processing using the pulsed laser beam, the pulse width of the laser beam is equal to the irradiated time of the laser beam. Thus, the narrower the pulse width is, the shallower the removed depth in the processed material per pulse becomes, and the wider the pulse width is, the deeper the removed depth therein per pulse becomes. Therefore, in the method according to this embodiment, when the copper foil 4 is processed, the pulse width of the laser beam is narrowed to be about 3 $\mu$s so as not to deeply process the copper foil 4 to reach the insulator 2. In addition, when the insulator 2 is processed, the pulse width of the laser beam is enlarged to be about 100 $\mu$s so as to make the removed depth per pulse larger to effectively process it.

Furthermore, according to the method of this embodiment, the pulse width of the laser beam is set to about 30 $\mu$s to 50 $\mu$s, when the copper foil 6 is processed. This is because if the laser beam having the smaller pulse width than that in the above range is irradiated onto the copper foil 6, the processing efficiency is lowered, and if the laser beam having the wider pulse width than that in the above range is irradiated to it, molten copper is increased and it is likely to be left in the vicinity of an opening of the through-hole 14 (refer to an embodiment 7 of the present invention).

The laser energy per pulse may be varied in order to vary the peak output of the laser beam. However, according to the laser processing method of this embodiment, by varying the pulse width of the laser beam during the laser processing, the processing time is shortened, as well as a part of the multilayer material is prevented from protruding into the through-hole 14, since the peak output (power density) of the laser beam and the irradiated time thereof can be varied at the same time.

In the laser processing of this embodiment, the printed circuit board 1, in which the uppermost and lowermost layers are conductor layers, is used, but an insulating layer may be further formed on the uppermost conductor layer and /or the lowermost conductor layer. The laser processing method according to this embodiment can be also applied to such a printed circuit board.

In this case, the same effect as above-mentioned can be obtained.

(Embodiment 2)

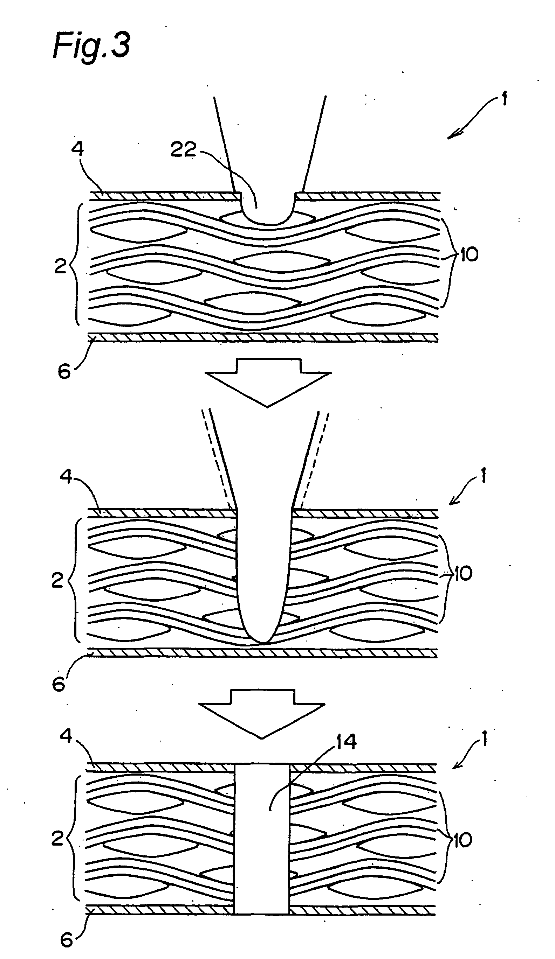

Fig. 3 is a diagram to explain steps of a method for a laser processing a multilayer material according to an embodiment 2 of the present invention. In the description of this embodiment, the multilayer material means a double-sided copper-clad printed circuit board (the glass epoxy substrate) 1 with a thickness of 0.4mm (the thicknesses of the copper foils are 12 $\mu$m). In the steps shown in Fig. 3, the through-hole 14 is formed by irradiating a pulsed carbon dioxide laser beam to this printed circuit board 1.

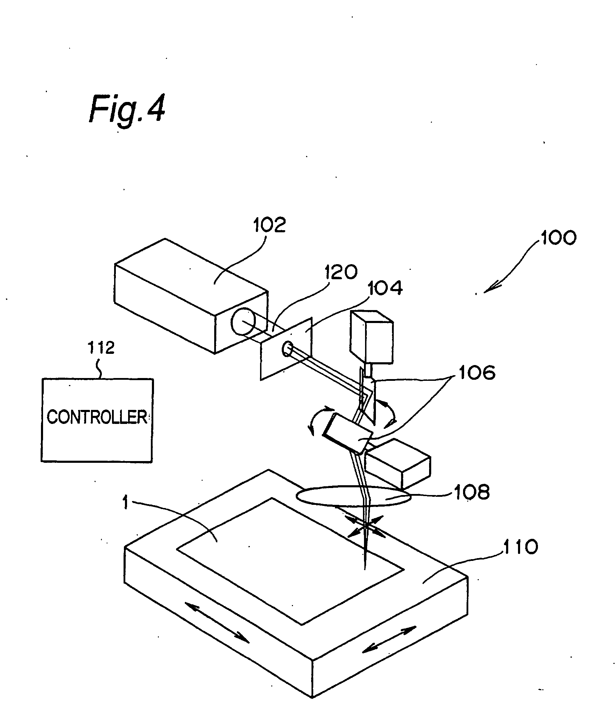

According to the laser processing method of this embodiment, a laser beam diameter at a processing point when processing the copper foil 4 is different from that when processing the insulator 2 and the copper foil 6. This is realized by a laser processing apparatus shown in Fig. 4. Fig. 4 shows a laser processing apparatus 100, which can vary the laser beam diameter at the processing point. The laser processing apparatus 100 includes a pulse carbon dioxide laser 102, a transfer mask 104, positioning mirrors (galvanometer mirrors) 106, a transfer lens 108 and a processing table 110. In addition, the laser processing apparatus 100 includes a controller 112 which electrically controls the operations of the above components. For example, the controller 112 makes the pulse carbon dioxide laser 110 oscillate a pulsed laser beam having a desired pulse width or desired energy per pulse. In addition, the controller 112 controls the rotations of the positioning mirrors 106, and positions the transfer mask 104 and the transfer lens 108 on an optical path. Furthermore, the controller 112 makes the processing table 110 move in parallel to a plane, on which the printed circuit board 1 is set. Referring to Fig. 4, connection between the controller 112 and each of the components is omitted for simplification.

Hereinafter, the operation of the laser processing apparatus 100 will be described. First, the laser beam is focused to about $\phi$ 120 $\mu$m on the copper foil 4, using the transfer mask 104 of $\phi$ 1.8mm and the transfer lens 108. More specifically, a part of the laser beam 120 emitted from the pulse carbon dioxide laser 102 passes the transfer mask 104 and two positioning mirrors 106, and reaches the transfer lens 108. The two positioning mirrors 106 decides an incident angle (incident position) of the laser beam to the transfer lens 108. The transfer lens 108 converges the incident laser beam, and forms an image of the transfer mask 104 on the printed circuit board 1, set on the processing table 110. The positioning of the printed circuit board 1 is performed by moving the processing table 110 on which the printed circuit board 1 is set. First, the pulse on time of the laser beam is set to 3 $\mu$s and laser energy per pulse is set to 24 mJ, and the laser beam is irradiated onto the copper foil 4 by one pulse to form a drilled hole 22 of $\phi$ 100 $\mu$m in the copper

foil 4 (Fig. 3).

Next, the insulator 2 is processed by irradiating the same position as the drilled hole 22 with four pulses of a laser beam in which the transfer mask 104 is changed to $\phi$ 1.2mm, the pulse on time of the laser beam is set to 100 $\mu$s, and laser energy per pulse is set to 10 mJ. Then, the copper foil 6 is processed by irradiating it with one pulse of laser beam, in which the pulse on time of the laser beam is set to 40 $\mu$s and the laser energy per pulse is set to 8 mJ. Here, the laser beam diameter at the processing point is about $\phi$ 100 $\mu$m. Through these steps, the through-hole 14 is formed in the printed circuit board 1.

An observation of a cross-section of the through-hole 14 by a microscope shows its hole diameter hardly changes and the direction of the central axis of the hole corresponds to the direction of the optical axis of the laser beam. In addition, it is found that protrusion of the copper foil 4 into the hole on the laser incoming side of the hole, and that of the copper foil 6 into the hole on the laser outgoing side of the hole are 5 $\mu$m or less.

According to the laser processing method of this embodiment, when at least the insulator 2 and the copper foil 6 are irradiated with a laser beam, a diameter of the laser beam is smaller than that of the drilled hole 22 formed in the copper foil 4. Thus, the diffraction of the laser beam caused by the drilled hole 22 can be prevented from generating, and the through-hole 14 is prevented from being swollen in the middle.

Furthermore, according to the laser processing method of this embodiment, the protrusion of the copper foil 4 into the through-hole 14 on the laser beam incoming side thereof can be prevented, since the diffraction of the laser beam caused by the drilled hole 22 is prevented from generating.

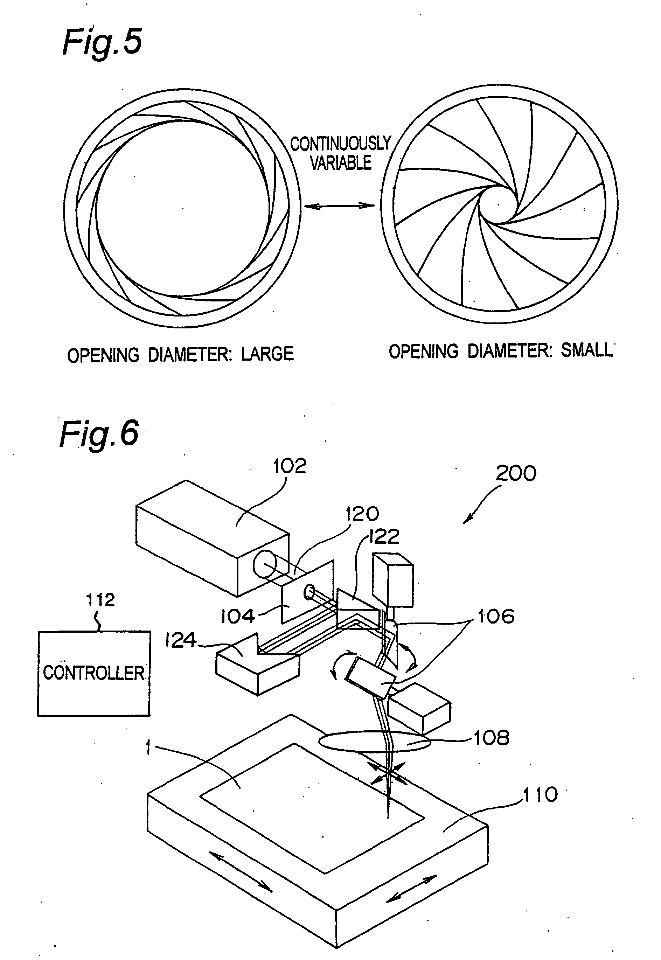

In the laser processing apparatus 100, the transfer mask 104 is exchanged from $\phi$ 1.8mm to $\phi$ 1.2mm during the process to change the laser beam diameter at the processing point. However, instead of the transfer mask 104, a beam aperture with a continuously variable opening diameter may be used as shown in Fig. 5. The laser beam diameter at the processing point on the printed circuit board 1 can be easily varied by connecting this beam aperture to the controller 112 and controlling its opening diameter. Thus, the above laser processing method can be easily implemented. In addition, the laser processing time can be shortened.

Furthermore, the same effect as described can be obtained when applying the laser processing method according to this embodiment to forming a blind hole or grooving in the printed circuit board 1, although forming the through-hole 14 in the printed circuit board is explained in this embodiment. For example, the configurations of the blind hole and the groove are prevented from becoming a configuration such as a trapezoid different from a desired configuration, and the copper foil 4 is prevented from protruding into the blind hole or the groove on the laser beam incoming side of the blind hole or the groove, by processing the insulator 2 with the laser beam having the smaller diameter at the processing point than the laser beam irradiated onto the copper foil 4 after forming the drilled hole 22.

Furthermore, an insulating layer may be further formed on the uppermost conductor layer and/or on the lowermost conductor layer, although the uppermost and lowermost layers are conductor layers in the printed circuit board 1 according to the laser processing method of this embodiment. Even in this case, the laser processing method according to this embodiment can be applied, and the same effect as described in this embodiment can be obtained.

Still further, even if continuously oscillating laser beam is used, the same effect as described above is obtained, by varying the power density of the laser beam or the laser beam diameter at the processing point in the laser processing, although the pulsed laser beam is used according to the laser processing method of this embodiment. In this case, the carbon dioxide laser 110 continuously oscillates the laser beam.

(Embodiment 3)

Fig. 6 is a diagram to explain a configuration of a laser processing apparatus 200 for a multilayer material according to an embodiment 3 of the present invention. The laser processing apparatus 200 has the configuration that a convex V-shaped mirror for adjusting an optical path length (referred to as a convex V-shaped mirror, hereinafter) 122 and a concave V-shaped mirror for adjusting an optical path length (referred to as a concave V-shaped mirror, hereinafter) 124 are added to the laser processing apparatus 100 shown in Fig. 4. Laser processing for the printed circuit board 1 is performed by using the laser processing apparatus 200 by the same method as described in the embodiment 2 (Fig. 3).

Here, the convex V-shaped mirror 122 is an optical element in which two reflective surfaces are coupled so as to be V-shaped to form a convex-shaped reflective surface, and the concave V-shaped mirror 124 is an optical element in which two reflective surfaces are coupled so as to be V-shaped to form a concave-shaped reflective surface. In the laser processing apparatus 200, the optical path length is varied by setting the convex V-shaped mirror 122 and the concave V-shaped mirror 124 in the optical path between the transfer mask 104 and the positioning mirrors 106. According to the laser processing apparatus 200 of this embodiment, an angle formed by the two reflective surfaces of the convex V-shaped mirror 122 and an angle formed by the two reflective surfaces of the concave V-shaped mirror 124 are both 90 degrees. One reflective surface (a first reflective surface) of the convex V-shaped mirror 122 is set so as to form 45 degrees with the laser beam passing through the transfer mask 104. The laser beam passing through the transfer mask 104 is reflected by the first reflective surface of the convex V-shaped mirror 122 toward the concave V-shaped mirror 124. The angle formed between the incident direction and reflected direction of the laser beam at the reflective surface of the convex V-shaped mirror 122 is 90 degrees. The laser beam reflected by the convex V-shaped mirror 122 reaches one (a first) reflective surface of the concave V-shaped mirror 124. Here, the first reflective surface of the concave V-shaped mirror 124 is set so as to form 45 degrees with the reflected beam reflected by the first reflective surface of the convex V-shaped mirror 122. The laser beam is reflected again by the first reflective surface of the concave V-shaped mirror 124. The angle formed between the incident direction and the reflected direction of the laser beam at the first reflective surface of the concave V-shaped mirror 124 is 90 degrees. The laser beam reflected by the first reflective surface of the concave V-shaped mirror 124 reaches the other (a second) reflective surface of the concave V-shaped mirror 124. Then, the laser beam, which reached the second reflective surface of the concave V-shaped mirror 124, is reflected by this reflective surface toward the convex V-shaped mirror 122. The angle formed between the incident direction and the reflected direction of the laser beam at the second reflective surface of the concave V-shaped mirror 124 is 90 degrees. The laser beam reflected by the second reflective surface of the concave V-shaped mirror 124 reaches a second reflective surface of the convex V-shaped mirror 122. The second reflective surface of the convex V-shaped mirror 122 reflects the laser beam so as to lead it to the positioning mirror 106. The angle formed between the incident direction and the reflected direction of the laser beam at the second reflective surface of the convex V-shaped mirror 122 is 90 degrees. Using the above configuration, the optical path length can be varied in the laser processing apparatus 200 by fixing the convex V-shaped mirror 122 and moving the concave V-shaped mirror 124 in parallel to the laser beam between the convex V-shaped mirror 122 and the concave V-shaped mirror 124.

Hereinafter, it is described about the operation of the laser processing apparatus 200. First, the laser beam is focused to about $\phi$ 120 $\mu$m on the copper foil 4 by using the transfer mask 104 of $\phi$ 1.8mm and the transfer lens 108. More specifically, a part of the laser beam 120 emitted from the pulse carbon dioxide laser 102 passes the transfer mask 104, the convex V-shaped mirror 122, the concave V-shaped mirror 124 and two positioning mirrors 106, and reaches the transfer lens 108. The two positioning mirrors 106 decide an incident angle (incident position) of the laser beam to the transfer lens 108. The transfer lens 108 converges the incident laser beam, and forms an image of the transfer mask 104 on the printed circuit board 1, set on the processing table 110. First, one pulse of the laser beam is irradiated to form a drilled hole 22 of $\phi$ 100 $\mu$m in the copper foil 4

with the pulse on time of the laser beam set to 3 μs and the laser energy per pulse set to 24 mJ.

Then, the convex V-shaped mirror 122 is fixed and the concave V-shaped mirror 124 is moved so as to be apart from the convex V-shaped mirror 122 in parallel to the laser beam between the convex V-shaped mirror 122 and the concave V-shaped mirror 124, while the transfer mask 104 is kept at φ 1.8mm. The transfer lens 108 is brought close to the printed circuit board 1, set on the processing table 110. The positioning of these components is performed by a controller 112. Then, the laser beam is irradiated onto the same position as the drilled hole 22 for four pulses with the pulse on time of the laser beam set to 3 μs and the laser energy per pulse set to 11 mJ, to process the insulator 2. Then, the laser beam is irradiated for one pulse to the same position with the pulse on time of the laser beam set to 40 μs and the laser energy per pulse set to 8 mJ, to process the copper foil 6. Here, a laser beam diameter at the processing point is about φ 100 μm. Through these steps, a through-hole 14 is formed in the printed circuit board 1.

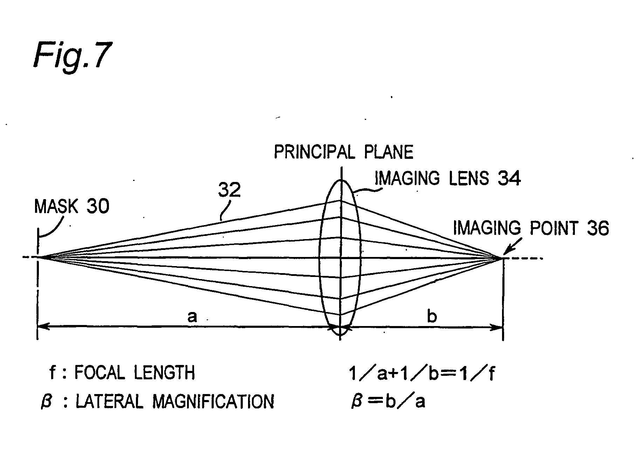

It is described about the reason why the beam diameter at the processing point is varied by changing the optical path length between the transfer mask 104 and the transfer lens 108. Fig. 7 shows a basic configuration of imaging optics. A laser beam 32 passing a mask 30 (transfer mask 104) is converged to an imaging point 36 (the processing point on the printed circuit board 1) by an imaging lens 34 (transfer lens 104). In this optics, the following equation (3) is provided.

$$1 / a + 1 / b = 1 / f \qquad (3)$$

where "a" is a distance between the mask 30 and a principal plane of the imaging lens 34 (hereinafter, referred to as a mask-lens distance), "b" is a distance between a principal plane of the imaging lens 34 and the imaging point 36 (referred to as the lens-imaging point distance, hereinafter), and "f" is a focal distance of the imaging lens 34.

Referring to the equation (3), the image of the mask 30 is formed by b/a times as large as the mask (lateral magnification β = b/a). When the lateral magnification β is represented by the mask-lens distance "a" and the focal distance "f", the following equation (4) is provided.

$$\beta = f / (a - f) \qquad (4)$$

Referring to the equation (4), if the focal distance f is constant, the lateral magnification β is continuously varied by making the mask-lens distance "a" variable. Thus, the beam diameter at the processing point is varied by varying the optical path length between the transfer mask 104 (the mask 30) and the transfer lens 108 (the imaging lens 34).

In addition, when the lens-imaging point distance "b" is represented by the mask-lens distance "a" and the focal distance "f", the following equation (5) is provided.

$$b = fa / (a-f) \qquad (5)$$

Referring to the equation (5), if the focal distance "f" is constant, it is necessary to vary the lens-imaging point distance "b" in order to make the mask-lens distance "a" variable. Therefore, it is necessary to vary the distance between the transfer lens 108 and the printed circuit board 1 at the same time when the optical path length between the transfer mask 104 and the transfer lens 108 is varied. According to the laser processing apparatus 200 of this embodiment, the above mask-lens distance "a" can be varied by varying the distance between the convex V-shaped mirror 122 and the concave V-shaped mirror 124. Further, in conjunction with this variation, the above lens-imaging point "b" can be varied by varying the distance between the transfer lens 108 and the printed circuit board 1, set on the processing table 110.

According to the laser processing apparatus 200 of this embodiment, the beam diameter at the processing point is varied by varying the optical path length between the transfer mask 104 and the transfer lens 108, by using the convex V-shaped mirror 122 and the concave V-shaped mirror 124. As the most simple method of varying the optical path length between the transfer mask 104 and the transfer lens 108, there is a method of moving the position of the transfer mask 104 by using the controller 112 or the like in the laser processing apparatus 100 described in the embodiment 2. However, if the transfer mask 104 is movable in a wide range, the laser processing apparatus 200 becomes large in shape. For example, if the transfer magnification is made to be 2/3, it is necessary to increase the distance between the transfer mask 104 and the transfer lens 108 by half. If the optical path length is adjusted by diverting the optical path between the transfer mask 104 and the transfer lens 108 by using the convex V-shaped mirror 122 and the concave V-shaped mirror 124, as in the laser processing apparatus 200, the laser processing apparatus is prevented from becoming larger in shape.

In addition, even if the laser processing apparatus according to this embodiment is used, the same effect can be obtained as described in the embodiment 2.

(Embodiment 4)

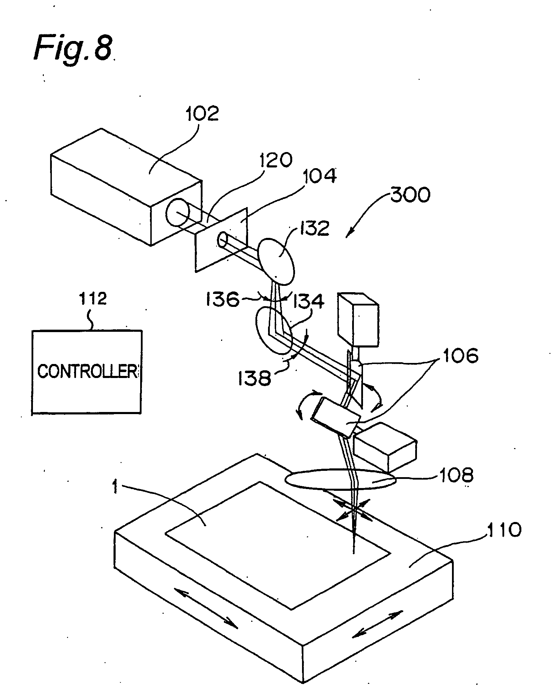

Fig. 8 is a diagram to explain a configuration of a laser processing apparatus 300 for a multilayer material according to an embodiment 4 of the present invention. The laser processing apparatus 300 has a configuration that a reflective surface shape variable reflecting mirror for adjusting magnification (referred to as a reflective surface shape variable reflecting mirror) 132 and a reflective surface shape variable reflecting mirror 134 are added to the laser processing apparatus 100 shown in Fig. 4. The reflective surface shape variable reflecting mirror can control a divergence angle of an incident laser beam by varying the shape of the reflective surface. The two reflective surface shape variable reflecting mirrors 132 and 134 are set in the optical path between the transfer mask 104 and the positioning mirror 106. Their shapes of the reflective surfaces are controlled by the controller 112. Laser processing for a printed circuit board 1 is performed by using the laser processing apparatus 300, by the same method as described in the embodiment 2 (Fig. 3).

Hereinafter, it is described about the operation of the laser processing apparatus 300. First, the laser beam is focused to about $\phi$ 120 $\mu$m on the copper foil 4 by using the transfer mask 104 of $\phi$ 1.8mm and the transfer lens 108. More specifically, a part of the laser beam 120 emitted from the pulse carbon dioxide laser 102 passes the transfer mask 104, the reflective surface shape variable reflecting mirrors 132 and 134, and two positioning mirrors 106, and reaches the transfer lens 108. At first, the reflective surfaces of the reflective surface shape variable reflecting mirrors 132 and 134 are both flat, and they operate as normal reflecting mirrors. The two positioning mirrors 106 decide an incident angle (incident position) of the laser beam to the transfer lens 108. The transfer lens 108 converges the incident laser beam, and forms an image of the transfer mask 104 on the printed circuit board 1, set on the processing table 110. First, one pulse of the laser beam is irradiated to form a drilled hole 22 of $\phi$ 100 $\mu$m in the copper foil 4, with the pulse on time of the laser beam set to 3 $\mu$s, and the laser energy per pulse set to 24 mJ.

Then, while the transfer mask is kept at $\phi$ 1.8mm, the reflective surface of the reflective surface shape variable reflecting mirror 132 is changed to a convex surface, and the reflective surface of the reflective surface shape variable reflecting mirror 134 is changed to a concave surface. The reflective surface shape variable reflecting mirrors 132 and 134 control beam divergence angles 136 and 138, respectively. Next, the laser beam, of which divergence angle is controlled, is irradiated onto the same position as the drilled hole 22 for four pulses to process the insulator 2 with the pulse on time of the laser beam set to 3 $\mu$s and the laser energy per pulse is set to 11 mJ. Then, the laser beam is irradiated for one pulse onto the same position to process the copper foil 6 with the pulse on time of the laser beam set to 40 $\mu$s and the laser energy per pulse set to 8 mJ. Here, a laser beam diameter at the processing point is about $\phi$ 100 $\mu$m. Through these' steps, the through-hole 14 is formed in the printed circuit board 1.

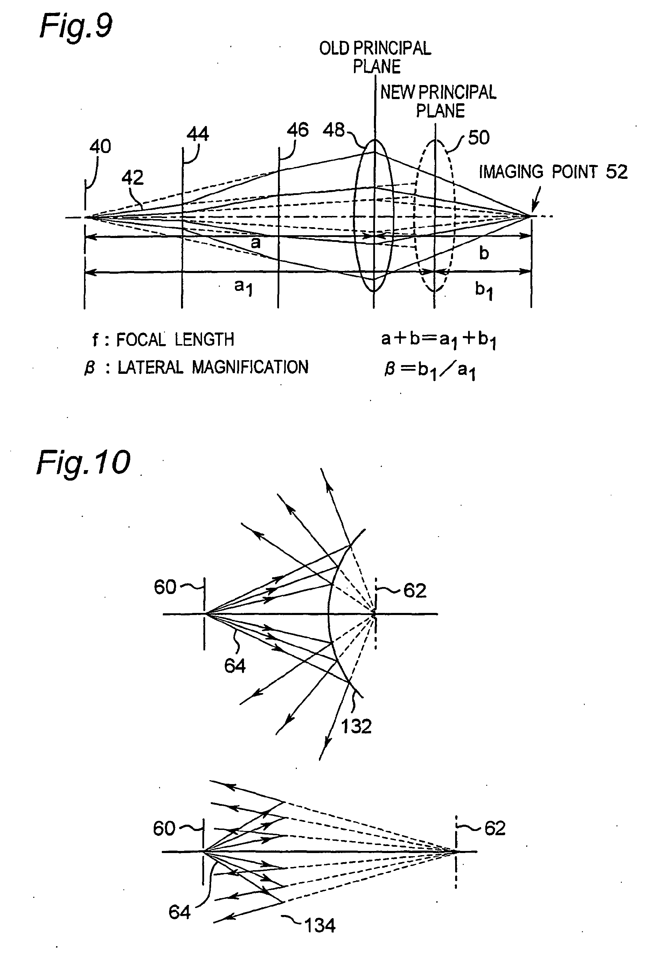

Hereinafter, it is described why the beam diameter at the processing point is varied by varying the shapes of the reflective surfaces of the reflective surface shape variable reflecting mirrors 132 and 134. Fig. 9 shows a basic configuration of imaging optics in which a convex mirror and a concave mirror are used. Referring to Fig. 9, the beam divergence angle of a laser beam 42 passing a mask 40 (a transfer mask 104) is changed by two mirrors 44 and 46 (the reflective surface shape variable reflecting mirrors 132 and 134), whose surface shapes has been changed, before the laser beam enters an imaging lens 48 (a transfer lens 108). This corresponds to that the lens position of the imaging lens 48 is artificially moved. At this time, the following equation (6) is provided.

$$a + b = a_1 + b_1$$

$$\beta = b_1 / a_1 \qquad (6)$$

where "a" is a distance between the mask 40 and a principal plane of the imaging lens 48 (referred to as the mask-lens distance, hereinafter), "b" is a distance between the principal plane of the imaging lens 48 and the imaging point 52 (a processing point on the printed circuit board 1) ( referred to as the lens-imaging point distance, hereinafter), "$a_1$" is a distance between the mask 40 and' the principal plane of an artificial lens 50 (referred to as the artificial mask-lens distance, hereinafter) and "$b_1$" is a distance between the principal plane of the artificial lens 50 and the imaging point 52 (referred to as the artificial lens-imaging point distance, hereinafter).

Referring to the equation (6), lateral magnification $\beta$ is decided by the artificial mask-lens distance "$a_1$" and the artificial lens-imaging point distance "$b_1$". As a result, the lateral magnification $\beta$ can be continuously varied, since the artificial mask-lens distance "$a_1$" and the artificial lens-imaging point distance "$b_1$" can be continuously varied by varying the shapes of the reflective surfaces of the reflective surface shape variable reflecting mirrors 132 and 134.

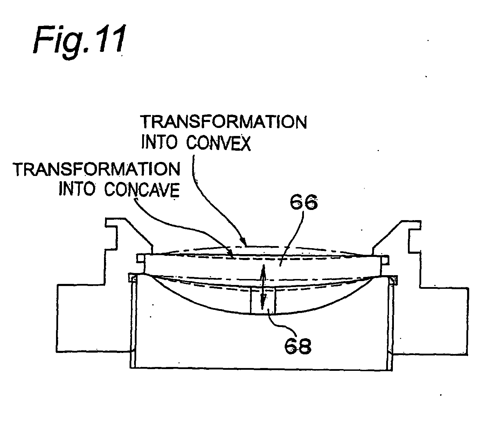

As shown in Fig. 10, each of the reflective surface shapes of the reflective surface shape variable reflecting mirrors 132 and 134 is a part of hyperboloid of revolution. When the hyperboloid of revolution is used, the beam divergence angle of the laser beam 64 can be varied, since the distance between the reflective surface and the mask 60 is differentiated from the distance between the reflective surface and a virtual image 62 of the mask. Fig. 11 shows a shape of one of the reflective surface shape variable reflecting mirrors 132 and 134 used in the laser processing apparatus 300 according to this embodiment. As shown in Fig. 11, a reflecting mirror 66 is joined to a piezoelectric device 68 at a point on its back surface. When a voltage is applied to this piezoelectric device 68 by using a controller 112, the piezoelectric device 68 expands and contracts, and applies an external force to the back surface of the reflecting mirror 66. When the external force is applied by the piezoelectric device 68, the reflective surface of the reflecting mirror 66 becomes a desired shape (forming a part of the convex or concave hyperboloid of revolution).

According to the laser processing apparatus 300 of this embodiment, the transfer magnification can be varied at high speed, since the reflecting mirror 66, whose reflective surface is transformed into convex or concave shape by the piezoelectric device 68, is employed. Therefore, the laser processing time can be shortened.

Furthermore, the beam diameter at the processing point can be also changed when the reflective surfaces of the reflective surface shape variable reflecting mirrors 132 and 134 are both changed to the convex shapes, although they are changed into the convex and concave shapes, respectively, in the laser processing apparatus 300 according to this embodiment.

When the laser processing is performed according to the steps shown in Fig. 3 by using the laser processing apparatus 300 of this embodiment, the insulator 2 and the copper foil 6 are processed by changing the reflective surfaces of the two reflective surface shape variable reflecting mirrors 132 and 134, after the hole in the copper foil 4 is formed. However, even in the reverse case, that is, the reflective surfaces of the two reflective surface shape variable reflecting mirrors 132 and 134 are varied to process the hole in the copper foil 4, and then they is reversed to be flat to process the insulator 2 and the copper foil 6, the same effect as described in this embodiment can be obtained.

In addition, also when the laser processing apparatus according to this embodiment is used, the same effect as described in the embodiment 2 can be obtained.

(Embodiment 5)

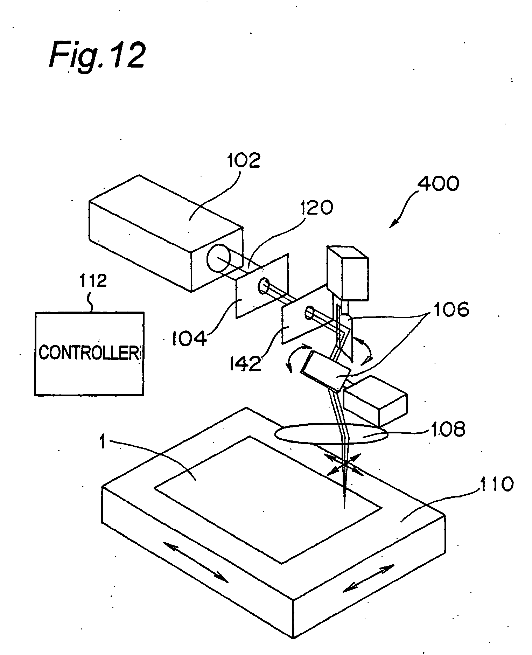

Fig. 12 is a diagram to explain the configuration of a laser processing apparatus 400 for a multilayer material according to an embodiment 5 of the present invention. The laser processing apparatus 400 has a configuration that an opening diameter continuously variable beam aperture 142 (Fig. 5) is added to the laser processing apparatus 100 shown in Fig. 4. The opening diameter continuously variable beam aperture 142 is set in the optical path between the transfer mask 104 and the positioning mirrors 106, and its opening diameter is controlled by the controller 112. Laser processing for the printed circuit board 1 is performed by using the laser processing apparatus 400 by the same method as described in the embodiment 2 (Fig. 3).

Hereinafter, it is described about the operation of the laser processing apparatus 400. First, the laser beam is focused to about $\phi$ 120 $\mu$m on the copper foil 4 by using the transfer mask 104 of $\phi$ 1.2mm, the opening diameter continuously variable beam aperture 142 and the transfer lens 108. More specifically, a part of the laser beam 120 emitted from the pulse carbon dioxide laser 102 passes the transfer mask 104, and is narrowed by the opening diameter continuously variable beam aperture 142. The opening diameter continuously variable beam aperture 142 narrows the laser beam diameter which is diffracted and enlarged by the transfer mask 104. Here, the opening diameter continuously variable beam aperture 142, having the opening diameter of $\phi$ 18mm, is set to a position apart from the transfer mask 104 by 1200 mm. The laser beam narrowed by the opening diameter continuously variable beam aperture 142 passes the two positioning mirrors 106, and reaches a transfer lens 108. The two positioning mirrors 106 control an incident angle (incident position) of the laser beam to the transfer lens 108. The transfer lens 108 converges the incident laser beam and forms an image of the transfer mask 104 on the printed circuit board 1, set on the processing table 110. First, one pulse of the laser beam is irradiated to form a drilled hole 22 of $\phi$ 100 $\mu$m in the copper foil 4 with the pulse on time of the laser beam set to 3 $\mu$s and the laser energy per pulse set to 24 mJ (Fig. 3) .

Then, while the transfer mask 104 is kept at $\phi$ 1.2mm, the opening diameter of the opening diameter continuously variable beam aperture 142 is enlarged up to $\phi$ 36mm by using a controller 112. Then, the laser beam is irradiated onto the same position as the drilled hole 22 for four pulses to process the insulator 2 with the pulse on time of the laser beam set to 3 $\mu$s and the laser energy per pulse set to 11 mJ. Then, the laser beam is irradiated for one pulse onto the same position to process the copper foil 6 with the pulse on time of the laser beam set to 40 $\mu$s and the laser energy per pulse set to 8 mJ. Here, a diameter of a laser beam at the processing point is about $\phi$ 100 $\mu$m. Through these steps, the through-hole 14 is formed in the printed circuit board 1.

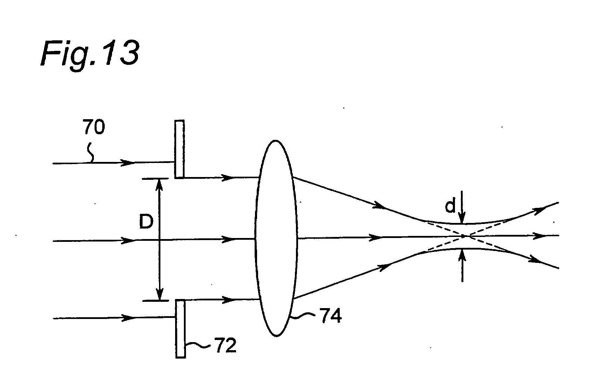

Hereinafter, it is described why the beam diameter at the processing point is varied by varying the opening diameter of the opening diameter continuously variable beam aperture 142. Fig. 13 shows a converging state by the opening and the lens. When a laser beam 70, which is parallel to an opening 72 (the opening diameter continuously variable beam aperture 142), is irradiated, the laser beam passing the opening 72 is narrowed by a lens 74 (the transfer lens 108). A beam diameter "d" at the converging point (the processing point on the printed circuit board 1) narrowed by the lens 74 is represented by the following equation (7).

$$d = 2.44 \times \lambda \times f/D \qquad (7).$$

where "$\lambda$" is a wavelength of the laser beam 70, "f" is a focal distance of the lens 74, and "D" is an opening diameter.

Referring to the equation (7), the opening diameter "D" is inversely proportional to the beam diameter "d". Thus, the beam diameter "d" at the converging point can be decreased by increasing the opening diameter "D", and increased by decreasing the opening diameter "D".

According to the laser processing apparatus 400 of this embodiment, it is not necessary to replace the transfer mask 104 in the laser processing apparatus 100 shown in Fig. 4 with another transfer mask having a different diameter, since the opening diameter continuously variable beam aperture 142 is provided. In addition, the laser processing time can be shortened. Furthermore, according to the laser processing apparatus 400 of this embodiment, the beam diameter at the processing point of the multilayer material can be varied with higher precision, since the laser beam, which is diffracted and enlarged by the transfer mask 104, is continuously narrowed by the opening diameter continuously variable beam aperture 142.

In addition, also when the laser processing apparatus according to this embodiment is used, the same effect as described in the embodiment 2 can be obtained.

(Embodiment 6)

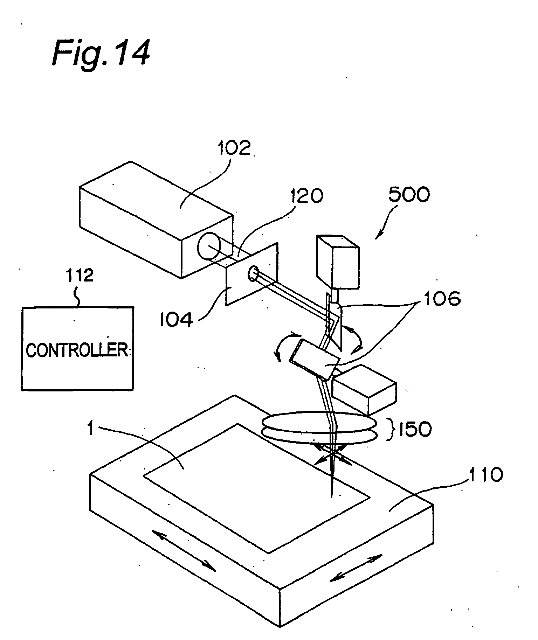

Fig. 14 is a diagram to explain a configuration of a laser processing apparatus 500 for a multilayer material according to an embodiment 6 of the present invention. The laser processing apparatus 500 has a configuration that the transfer lens 108 in the laser processing apparatus 100 shown in Fig. 4 is replaced with a focal distance variable transfer lens 150. A focal distance of the focal distance variable transfer lens 150 is controlled by the controller 112. Laser processing for a printed circuit board 1 is performed by using the laser processing apparatus 500 by the same method as described in the embodiment 2 (Fig. 3).

Hereinafter, it is described about the operation of the laser processing apparatus 500. First, the laser beam is focused to about $\phi$ 120 $\mu$m on the copper foil 4 by using the transfer mask 104 of $\phi$ 1.8mm and the focal distance variable transfer lens 150. More specifically, a part of the laser beam 120 emitted from the pulse carbon dioxide laser 102 passes the transfer mask 104 and the two positioning mirrors 106, and reaches the focal distance variable transfer lens 150. The two positioning mirrors 106 decide an incident angle (incident position) of the laser beam to the focal distance variable transfer lens 150. The focal distance variable transfer lens 150 converges the incident laser beam, and forms an image of the transfer mask 104 on the printed circuit board 1, set on a processing table 110. Then, one pulse of the laser beam is irradiated to form a drilled hole 22 of $\phi$ 100 $\mu$m in the copper foil 4 with the pulse on time of the laser beam set to 3 $\mu$s and the laser energy per pulse set to 24 mJ.

Then, while the transfer mask is kept at $\phi$ 1.8mm, the focal distance of the focal distance variable transfer lens 150 is shortened, and the laser beam is irradiated onto the same position as the drilled hole 22 for four pulses to process the insulator 2 with the pulse on time of the laser beam set to 3 $\mu$s and the laser energy per pulse set to 11 mJ. Then, the laser beam is irradiated for one pulse onto the same position to process the copper foil 6, with the pulse on time of the laser beam set to 40 $\mu$s and the laser energy per pulse set to 8 mJ. Here, a laser beam diameter at the processing point is about $\phi$ 100 $\mu$m. Through these steps, the through-hole 14 is formed in the printed circuit board 1.

Hereinafter, it is described why the beam diameter at the processing point is varied by varying the focal distance of the focal distance variable transfer lens 150. If the focal distance of the focal distance variable transfer lens 150 is varied from the focal distance "f" to a focal distance "$f_2$", the following equation (8) is provided with reference to Fig. 7 and the equation (3).

$$1 / a_2 + 1 / b_2 = 1 / f_2 \qquad (8)$$

where "$a_2$" is a distance between a new mask (the transfer mask 104) and a principle plane of an imaging lens (a transfer lens 108) (referred to as a new mask-lens distance, hereinafter), "$b_2$" is a distance between a principle plane of a new imaging lens and an imaging point (the processing point on the printed circuit board 1) (referred to as a new lens-imaging point distance, hereinafter).

In addition, according to the laser processing apparatus 500, there is provided the relation that the sum of mask-lens distance "a" plus lens-imaging point distance "b" is constant, and therefore the following equation (9) is provided.

$$a + b = a_2 + b_2 \qquad (9)$$

The new mask-lens distance "$a_2$" and the new lens-imaging point distance "$b_2$" are changed so as to satisfy the equations (8) and (9). If the new mask-lens distance "$a_2$" and the new lens-imaging point distance "$b_2$" are varied by varying the focal distance "$f_2$", the lateral magnification $\beta$ ($\beta = b_2/a_2$) is also varied. Thus, the beam diameter at the processing point can be continuously varied.

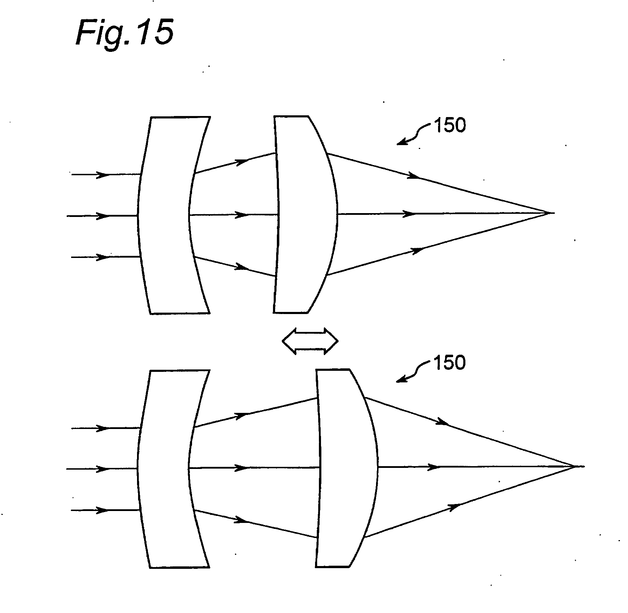

The focal distance variable transfer lens 150 is a lens assembly, which consists of two or more lenses, as shown in Fig. 15. The distances among the lenses, which constitute the lens assembly, are controlled by the controller 112. The focal distance of the focal distance variable transfer lens 150 can be varied by varying each distance among the lenses.

According to the laser processing apparatus 500 of this embodiment, it is not necessary to replace the transfer mask 104 in the laser processing apparatus 100 shown in Fig. 4 with another transfer mask having a different diameter, because of employing the focal distance variable transfer lens 150. In addition, the laser processing time can be shortened.

In addition, also when the laser processing apparatus according to this embodiment is used, the same effect as described in the embodiment 2 can be obtained.

(Embodiment 7)

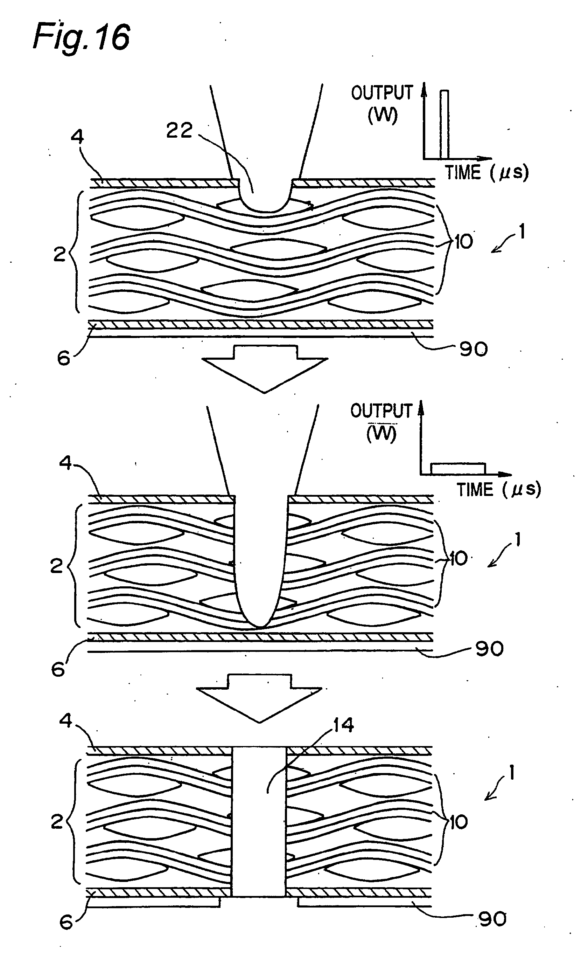

Fig. 16 is a diagram to explain steps of a laser processing method for a multilayer material according to an embodiment 7 of the present invention. In the description of this embodiment, the multilayer material means a double-sided copper-clad printed circuit board (the glass epoxy substrate) 1 with a thickness of 0.4mm (the thicknesses of the copper foils are 12 μm). Furthermore, according to the laser processing method of this embodiment, a PET sheet 90 having a thickness of 80 μm is attached to the copper foil 6 on the beam outgoing side of the printed circuit board 1 as an absorption layer. A pulsed laser beam emitted from a carbon dioxide laser is irradiated onto this printed circuit board 1 to form a through-hole 14 of φ 100 μm.

First, the laser beam is irradiated onto the copper foil 4 to form a drilled hole 22 in the surface of the copper foil 4. At this time, one pulse of the laser beam is irradiated with the pulse on time of the laser beam set to 3 μs and the laser energy per pulse set to 24 mJ, to form the drilled hole 22 of φ 100 μm in the copper foil 4.

Then, the laser beam is irradiated for four pulses onto the same position as the drilled hole 22, with the pulse on time of the laser beam set to 100 μs and the laser energy per pulse set to 10 mJ, to process the insulator 2. Then, the laser beam is irradiated for one pulse onto the same position, with the pulse on time of the laser beam set to 40 μs and the laser energy per pulse set to 8 mJ, to process the copper foil 6.

An observation of a cross-section of the through-hole 14 by a microscope shows that its hole diameter hardly changes, and the direction of the central axis of the hole corresponds to the direction of the optical axis of the laser beam. In addition, it is found that there are almost no protrusion of the copper foil 4 into the hole on the laser incoming side thereof, that of the copper foil 6 into the hole on the laser outgoing side thereof, and that of the glass cloth 10 into the hole.

In addition, when a hole diameter in the copper foil 6 is measured, the maximum of that is 100 μm and the minimum of that is 90 μm in the printed circuit board 1 with the PET 90. Meanwhile, when the normal printed circuit board without PET 90 is processed under the same laser beam condition, the maximum of the measured hole diameter is 100 μm and the minimum of that

is 80 μm.

According to the method of this embodiment, variation in the hole diameter in the copper foil 6 can be reduced by forming the hole with the PET sheet 90 attached to the copper foil 6. This is because the molten and re-coagulated copper foil 6 is prevented from retaining in the vicinity of the outlet of the through-hole 14. More particularly, when the temperature of the copper foil 6 is increased by irradiation with the laser beam, and the copper foil 6 is molten, the PET 90 attached to the copper foil 6 has already started to evaporate (The insulator 2 does not change, since it has the higher boiling point than the copper foil 6). When the PET 90 evaporates, the molten copper foil 6 is blown off together with the PET 90 from that position or through the through-hole 14 to the outside of the printed circuit board 1. Therefore, the molten copper foil 6 does not stay in the vicinity of the outlet of the through-hole 14.

According to the laser processing method of this embodiment, the same effect as in the embodiment 1 can be obtained.

In addition, the printed circuit board 1 in which the PET 90 is attached to the copper foil 6 can be processed by the laser processing method according to the embodiment 2 of the present invention.

Still further, in the laser processing method according to this embodiment, a PET is used as a laser beam absorbing material attached to the copper foil 6, but is not limited to this. For example, also when a polymeric material such as polybutylene terephthalate (PBT), polyamide (PA), polyetherimide (PEI) or polyimide (PI) is used, the same effect as described in this embodiment can be obtained.

In addition, an insulating layer may be further formed on the uppermost conductor layer, although the printed circuit board 1 in which the uppermost layer is conductor layer is used in the laser processing method according to this embodiment. Even in that case, the laser processing method according to this embodiment can be applied, and the same effect as described in this embodiment can be obtained.

(Embodiment 8)

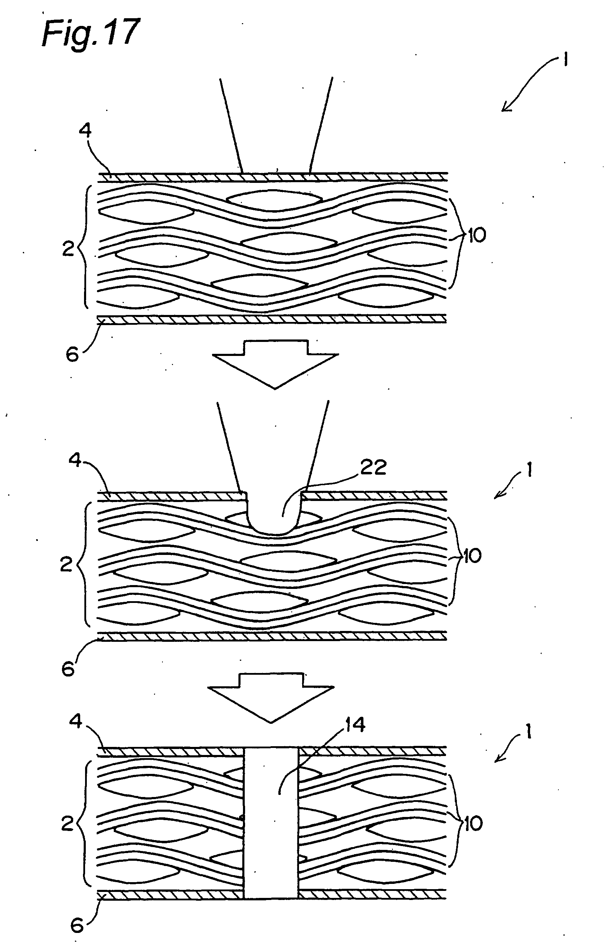

Fig. 17 is a diagram to explain steps of a laser processing method for a multilayer material according to an embodiment 8 of the present invention. In the description of this embodiment, the multilayer material means a double-sided copper-clad printed circuit board (the glass epoxy substrate) 1 with a thickness of 0.4mm (the thicknesses of the copper foils are 12 μm). According to the laser processing method of this embodiment, the copper foil 4 to be processed is previously heated. The pulsed laser beam of a carbon dioxide laser is irradiated onto this previously heated printed circuit board 1 to form a through-hole 14 of φ 100 μm.

First, the laser beam is irradiated onto the copper foil 4 to raise the surface temperature of the copper foil 4. At this time, three pulses of the laser beam is irradiated at 4kHz, with the pulse on time of the laser beam set to 3 μs and the laser energy per pulse set to 3 mJ, to heat the surface of the copper foil 4 up to about 300°C (573K). Then, one pulse of the laser beam is irradiated onto the same position in the copper foil 4 with the pulse on time of the laser beam set to 3 μs and the laser energy per pulse set to 24 mJ, to form a drilled hole 22 of φ 100 μm in the copper foil 4.

Then, the laser beam is irradiated for four pulses to the same position as the drilled hole 22, with the pulse on time of the laser beam set to 100 μs and the laser energy per pulse set to 10 mJ, to process the insulator 2. Then, one pulse of the laser beam is irradiated onto the same position, with the pulse on time of the laser beam set to 40 μs and the laser energy per pulse set to 8 mJ, to process the copper foil 6.

An observation of a cross-section of the through-hole 14 by a microscope shows that its hole diameter hardly changes and the direction of the central axis of the hole corresponds to the direction of the optical axis of the laser beam. Furthermore, it is found that there are almost no protrusion of the copper foil 4 into the hole on the laser incoming side thereof, that of the copper foil 6 into the hole on the laser outgoing side thereof, and that of the glass cloth 10 into the hole. In addition, when the hole diameter of the copper foil 4 is measured, the maximum and the minimum are 110 μm and 100 μm, respectively. Meanwhile, according to the normal substrate which is not heated previously, the measured maximum and minimum hole diameter of the copper foil 4 is are 110 μm and 90 μm, respectively.

According to the method of this embodiment, the variation of the hole diameter can be reduced, by previously heating up a part of the copper foil in which the hole is formed. This is because a laser beam absorption factor of copper is increased by heating so that copper can be stably processed. This will be described in detail hereinafter.

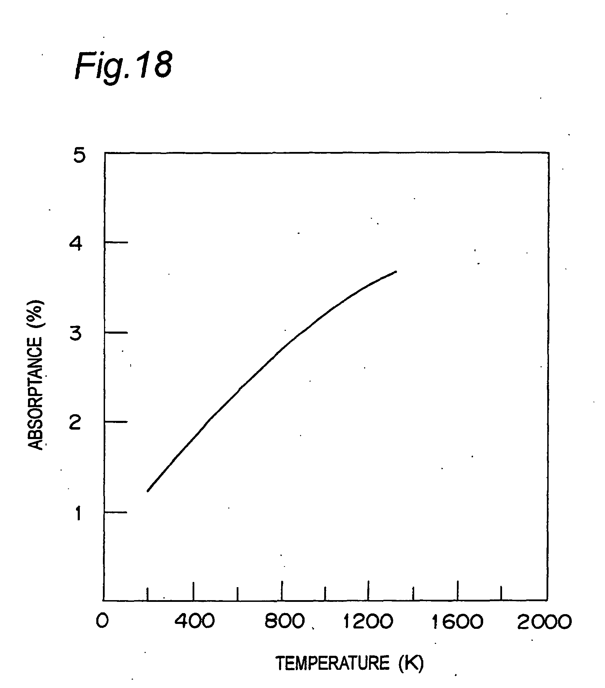

As described above, it is difficult to process copper by laser beam, since copper has relatively high reflection coefficient of the laser beam, and high thermal conductivity, in general. Especially, it is difficult to process the copper foil such as the copper foils 4 and 6 formed uniformly on the surface of the printed circuit board, since it reflects almost 99% of the irradiated carbon dioxide laser beam, when the carbon dioxide laser beam is irradiated to its uniform surface. However, when copper is heated up, the absorption factor of the carbon dioxide laser beam is increased. Fig. 18 is a graph of temperature dependency of carbon dioxide laser absorptance of copper. Here, the axis of abscissas represents a temperature of copper, and the axis of ordinate represents a carbon dioxide laser absorpance of copper.

According to the graph shown in Fig. 18, when the temperature of copper is raised, the carbon dioxide laser absorptance of copper is increased. For example, when the copper foil 4 is heated up from a room temperature (about 300K) up to about 573K in the laser processing method of this embodiment, the carbon dioxide laser absorptance of the copper foil 4 is increased by about 0.8%. As a result, the laser energy is absorbed about two times as much as when the temperature is not increased in the copper foil 4, and then the copper foil 4 can be stably processed, and the variation in hole diameter of the copper foil 4 is reduced.

In addition, the copper foil 4 may be heated up by another method, although the laser beam is used to heat up the copper foil 4 in the laser processing method of this embodiment.

Furthermore, the same effect can be obtained with respect to the copper foil 6 as with respect to the copper foil 4, if the copper foil 6 is heated up, although only the copper foil 4 is heated up in the laser processing method of this embodiment.

Still further, according to the laser processing method for the multilayer material of this embodiment, the same effect as in the embodiment 1 can be obtained.

Furthermore, the printed circuit board 1 may be processed by the method according to the embodiment 2, after the copper foil 4 is processed.

Furthermore, an insulating layer may be further formed on the uppermost conductor layer and/or on the lowermost conductor layer, although the uppermost and lowermost layers are conductor layers in the printed circuit board 1 according to the laser processing method of this embodiment. Also in that case, the laser processing method according to this embodiment can be applied, and then the same effect as described in this embodiment can be obtained.

Furthermore, the same effect as described in this embodiment can be obtained when applying the laser processing method according to this embodiment to forming a blind hole or grooving in the printed circuit board 1, although forming the through-hole 14 in the printed circuit board is explained in this embodiment.

Still further, another conductive material may be used as the conductor layer of the printed circuit board 1, although it is a copper foil according to the embodiments 1 to 8 of the present invention. In addition, the insulator 2 of the printed circuit board 1 is not limited to glass epoxy resin, although it is glass epoxy resin in the above embodiments 1 to 8. For example, aramid resin, glass polyimide resin or the like may be used as the insulator 2.

It will be obvious to those having skill in the art that many changes may be made in the above-described details of the preferred embodiments of the present invention. The scope of the present invention, therefore, should be determined by the following claims.

## Claims

**1.** A method for processing a multilayer material, in which one or more conductor layers and insulating layers are layered, with a laser beam, comprising the steps of:

irradiating said conductor layer with a first laser beam to form a hole at a processing point in said conductor layer; and
irradiating said hole with a second laser beam to process said insulating layer, layered on said conductor layer;

wherein said second laser beam has a smaller beam diameter at the processing point than said first laser beam.

2. A method for processing a multilayer material, in which one or more conductor layers and insulating layers are layered, with a laser beam to form a hole, comprising the steps of:

pre-heating a part of said conductor layer; and
irradiating said part heated in said pre-heating step with a laser beam to form said hole.

3. The method for processing a multilayer material with a laser beam according to claim 2, wherein said pre-heating step is performed by irradiating said part of said conductor layer with a laser beam.

4. A method for processing a multilayer material with a laser beam to form a through-hole in the multilayer material, in which a conductor layer and an insulating layer are layered, and which includes a multilayer consisting of two conductor layers and an insulating layer interposed between said two conductor layers, comprising the steps of:

irradiating a first conductor layer of said two conductor layers in said multilayer with a first laser beam to form a hole at a processing point in said first conductor;
irradiating said hole formed by said irradiating step for said first conductor layer with a second laser beam, having lower peak output than said first laser beam, to process said insulating layer in said multilayer, while a beam diameter at the processing point is kept constant; and
irradiating said hole formed by said irradiating step for said insulating layer with a third laser beam, having lower peak output than said first laser beam and having higher peak output than said second laser beam, to process a second conductor layer of said two conductor layer in said multilayer, while the beam diameter at the processing point is kept constant.

5. The method for processing a multilayer material with a laser beam according to claim 4, further comprising the step of forming a laser beam absorbing material on said second conductor layer before said irradiating step for the first conducting layer, wherein said second conductor layer of said multilayer is a surface layer of the multilayer material.

6. The method for processing a multilayer material with a laser beam according to claim 5, wherein said laser beam absorbing material is a polymeric material.

7. A laser processing apparatus for a multilayer material to irradiate the multilayer material, in which one or more conductor layers and insulating layers are layered, with a laser beam, comprising:

a laser which emits a pulsed laser beam, of which peak output is variable;
an opening which passes a part of said pulsed laser beam emitted from said laser;
a first optical system which varies an optical path of the laser beam passing said opening;
an imaging lens which forms an image of said opening; and
a controller which controls positions and operations of said laser, said opening, said first optical system and said imaging lens;

wherein said controller varies a size of said image of said opening.

8. The laser processing apparatus according to claim 7, further comprising a second optical system which varies an optical path length in an optical path between said opening and said first optical system;
wherein said controller controls said second optical system to vary a distance between said opening and said imaging lens.

9. The laser processing apparatus according to claim 7, further comprising a reflecting mirror in an optical path between said opening and said first optical system;
wherein said controller varies a shape of a reflective surface of said reflecting mirror.

10. The laser processing apparatus according to claim 9, wherein said controller makes the shape of the reflective surface of said reflecting mirror a part of hyperboloid of revolution.

11. The laser processing apparatus according to claim 9 or 10, wherein said controller varies the shape of the reflective surface of said reflecting mirror by controlling a piezoelectric device mounted on said reflecting mirror.

12. The laser processing apparatus according to claim 7, wherein said controller varies an opening diameter of said opening.

**13.** The laser processing apparatus according to claim 7, wherein said controller varies a focal distance of said imaging lens.

*Fig.1*

Fig.2

EP 1 386 689 A1

# Fig.3

## Fig.4

CONTROLLER

*Fig.5*

OPENING DIAMETER: LARGE

CONTINUOUSLY VARIABLE

OPENING DIAMETER: SMALL

*Fig.6*

## Fig.7

PRINCIPAL PLANE

IMAGING LENS 34

MASK 30

32

IMAGING POINT 36

a

b

f : FOCAL LENGTH

$1/a+1/b=1/f$

$\beta$ : LATERAL MAGNIFICATION

$\beta=b/a$

# Fig.8

CONTROLLER

## Fig.9

OLD PRINCIPAL
PLANE

NEW PRINCIPAL
PLANE

IMAGING POINT 52

40  42  44  46  48  50

a

$a_1$

b

$b_1$

f : FOCAL LENGTH

$\beta$ : LATERAL MAGNIFICATION

$a+b=a_1+b_1$

$\beta=b_1 / a_1$

## Fig.10

60  62  64  132

60  62  64  134

## Fig.11

TRANSFORMATION
INTO CONVEX

TRANSFORMATION
INTO CONCAVE

66

68

# Fig.12

## Fig.13

# Fig.14

*Fig.15*

## Fig.16

*Fig.17*

## Fig.18

Fig.19

# Fig.20

*Fig.21*

# INTERNATIONAL SEARCH REPORT

| | International application No. |
|---|---|
| | PCT/JP02/03150 |

| A. CLASSIFICATION OF SUBJECT MATTER |
|---|
| Int.Cl$^7$ B23K26/38, B23K26/40, H05K3/00, B23K101:42 |
| |
| According to International Patent Classification (IPC) or to both national classification and IPC |

| B. FIELDS SEARCHED |
|---|
| Minimum documentation searched (classification system followed by classification symbols) |
| Int.Cl$^7$ B23K26/38, B23K26/40, H05K3/00, B23K101:42 |

Documentation searched other than minimum documentation to the extent that such documents are included in the fields searched

| Jitsuyo Shinan Koho | 1922–1996 | Jitsuyo Shinan Toroku Koho | 1996–2002 |
| Kokai Jitsuyo Shinan Koho | 1971–2002 | Toroku Jitsuyo Shinan Koho | 1994–2002 |

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| P,X<br>P,A | JP 2001-313471 A (Matsushita Electric Works, Ltd.),<br>09 November, 2001 (09.11.01),<br>Claims 1, 7, 8; column 5, lines 4 to 10; column 5, line 43 to column 6, line 36; all drawings<br>(Family: none) | <u>1</u><br>2–13 |
| X<br>Y<br>A | JP 11-245071 A (Sumitomo Heavy Industries, Ltd.),<br>14 September, 1999 (14.09.99),<br>Claim 6; column 3, line 25 to column 6, line 29;<br>Figs. 1 to 2 (Family: none) | <u>7,12</u><br><u>9–11,13</u><br>1–6,8 |
| Y<br>A | US 5933218 A (Mitsubishi Denki Kabushiki Kaisha),<br>03 August, 1999 (03.08.99),<br>Column 10, line 38 to column 16, line 33; Figs. 7 to 32<br>& JP 9-293946 A | <u>11</u><br>1–10,12–13 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 24 June, 2002 (24.06.02) | 09 July, 2002 (09.07.02) |

| Name and mailing address of the ISA/<br>Japanese Patent Office | Authorized officer |
|---|---|
| Facsimile No. | Telephone No. |

Form PCT/ISA/210 (second sheet) (July 1998)

## INTERNATIONAL SEARCH REPORT

| International application No. |
| --- |
| PCT/JP02/03150 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y<br>A | JP 2000-71088 A  (Nisshinbo Industries, Inc.),<br>07 March, 2000 (07.03.00),<br>Column 3, lines 26 to 38; Fig. 2<br>(Family: none) | <u>11</u><br>1-10,12-13 |
| A | JP 11-274731 A  (Fujitsu Ltd.),<br>08 October, 1999 (08.10.99),<br>Claim 5<br>(Family: none) | 1-13 |
| E,A | JP 2002-118344 A  (Hitachi Via Mechanics, Ltd.),<br>19 April, 2002 (19.04.02),<br>Full text; all drawings<br>(Family: none) | 1-13 |

Form PCT/ISA/210 (continuation of second sheet) (July 1998)